# EUROPEAN PATENT APPLICATION

(11) **EP 2 811 309 A1**
(43) Date of publication of application: **10.12.2014**
(21) Application number: 14170902.2
(22) Date of filing: 03.06.2014
(51) Int. Cl.: G01R 31/317

(54) **Semiconductor circuit apparatus and electronic apparatus**

(30) Priority: 06.06.2013 JP 2013120176
(71) Applicant: FUJITSU LIMITED, Kawasaki-shi, Kanagawa 211-8588 (JP)
(72) Inventor: Higeta, Masanori, Kanagawa, 211-8588 (JP); Hayasaka, Kazumi, Kanagawa, 211-8588 (JP)
(74) Representative: Hoffmann Eitle

(57) **Abstract**

To provide a semiconductor circuit apparatus and an electronic apparatus that have improved utilization efficiency.

A semiconductor circuit apparatus includes a controller configured to output a control signal, an outputting part configured to output the control signal outside of the semiconductor circuit apparatus, a condition holding part configured to hold a generating condition and an output condition of a trigger signal, a trigger signal generator configured to generate the trigger signal, if the control signal satisfies the generating condition, a delay controller configured to give a delay to the trigger signal based on the output condition, and a selector configured to be disposed between the controller and the outputting part and to selectively output the trigger signal delayed at the delay controller to the outputting part instead of the control signal output from the controller based on the output condition.

## Description

### TECHNICAL FIELD

The disclosures discussed herein relate to a semiconductor circuit apparatus and an electronic apparatus.

### BACKGROUND ART

Conventionally, there has been an information processing unit which includes buses connecting a plurality of devices with each other, one or more signal lines which connect the devices and to which (an) identification-signal(s) is output, and an identification-signal-output-part which outputs the different identification-signals to each of the devices during a target operation period in which each of the devices is accessed by a master device (for example, patent document 1).

However, it is necessary that each of the devices of the conventional information processing unit includes one or more terminals via which the identification-signal(s) are output to the one or more signal lines.

The one or more terminals are used only for the sake of observing an operating state of the device(s) by using the external measuring device, and are not used when the device(s) is in a normal operating state in which the device(s) performs an arithmetic operation or the like.

Therefore, the devices of the conventional information processing unit have low utilization efficiency.

### [PRIOR ART REFERENCES]

### [PATENT REFERENCES]

### SUMMARY

Accordingly, it is an object in one aspect of the invention to provide a semiconductor circuit apparatus and an electronic apparatus that have improved utilization efficiency.

According to an aspect of an embodiment, there is provided a semiconductor circuit apparatus including a controller configured to output a control signal, an outputting part configured to output the control signal outside of the semiconductor circuit apparatus, a condition holding part configured to hold a generating condition and an output condition of a trigger signal, a trigger signal generator configured to generate the trigger signal, if the control signal satisfies the generating condition, a delay controller configured to give a delay to the trigger signal based on the output condition; and a selector configured to be disposed between the controller and the outputting part and to selectively output the trigger signal delayed at the delay controller to the outputting part instead of the control signal output from the controller based on the output condition.

### EFFECT OF INVENTION

According to an aspect of the above-described embodiments, there is provided a semiconductor circuit apparatus and an electronic apparatus that have improved utilization efficiency.

### BRIEF DESCRIPTION OF THE DRAWINGS

FIG. 1 is a diagram illustrating a state in which an oscilloscope is connected to an electronic apparatus according to a comparative example;
FIG. 2 is a diagram illustrating the waveforms of the signals obtained in the electronic apparatus of the comparative example;
FIG. 3 is a diagram illustrating a server including a semiconductor circuit apparatus and an electronic apparatus according to a first embodiment;
FIG. 4 is a diagram illustrating the electronic apparatus including a device of the first embodiment;
FIG. 5 is a timing diagram illustrating the waveforms of the signals output from the device of the first embodiment;
FIG. 6 is a diagram illustrating an electronic apparatus including a device of a second embodiment;
FIG. 7 is a diagram illustrating a trigger generator;
FIG. 8 is a diagram illustrating table data representing a generating condition, an output condition, a trigger pattern condition and a delay condition that are set in a control register;
FIG. 9 is a timing diagram illustrating waveforms of signals output from the device of the second embodiment;
FIG. 10 is a diagram illustrating processes carried out by a user of the device in order to determine a trigger signal;
FIG. 11 is a diagram illustrating an electronic apparatus including a device of a third embodiment;
FIG. 12 is a flowchart illustrating recording processes of log information performed by the device of the third embodiment;
FIG. 13 is a diagram illustrating a configuration of a log register 390 and a data configuration of log information; and
FIG. 14 is a timing diagram illustrating waveforms of signals output from the device 300 of the third embodiment.

### MODE FOR CARRYING OUT THE INVENTION

A description is given, with reference to the accompanying drawings, of embodiments of a semiconductor circuit apparatus and an electronic apparatus.

Here, a semiconductor circuit apparatus and an electronic apparatus according to a comparative example will be described before describing a semiconductor circuit apparatus and an electronic apparatus according to first to third embodiments.

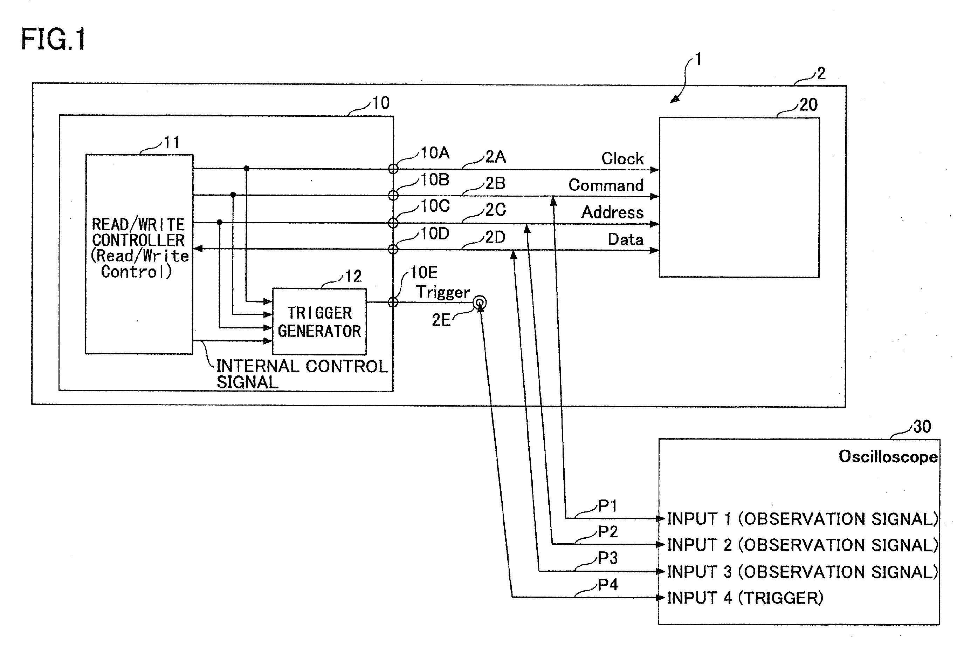

FIG. 1 is a diagram illustrating a state in which an oscilloscope 30 is connected to an electronic apparatus 1 according to the comparative example.

The electronic apparatus 1 includes a circuit board 2 and devices 10 and 20. The electronic apparatus 1 is a part of a server, for example. The devices 10 and 20 are made by utilizing a semiconductor manufacturing technique, for example. More precisely, the device 10 is a controller performing a control operation, and the device 20 is a memory storing data, for example.

Here, for example, a case where the device 10 which functions as the controller performs a write operation or a read operation of the data to or from the device 20 which functions as the memory will be described.

The circuit board 2 is an FR-4 (Flame Retardant type 4) standardized multi-layer printed circuit board, for example. The devices 10 and 20 are mounted on the circuit board 2. The circuit board 2 is a so-called mother board. Buses and traces that connect the devices 10 and 20 are formed on a top surface and a bottom surface of the circuit board 2 and in inner layers of the circuit board 2. Traces that feed power to the devices 10 and 20 are formed in the inner layers of the circuit board 2. A power source layer(s) and a grounded layer(s) are formed in the inner layers of the circuit board 2.

The device 10 includes a read/write controller (Read/Write Control) 11 and a trigger generator 12, and performs the write operation of the data to the device 20 and the read operation of the data written in the device 20.

The device 10 includes terminals 10A, 10B, 10C, 10D and 10E. The terminals 10A, 10B, 10C, 10D and 10E are connected to buses 2A, 2B, 2C and 2D and a trigger signal terminal 2E of the circuit board 2, respectively.

The read/write controller 11 is realized by a Central Processing Unit (CPU) chip, for example. The read/write controller 11, i.e., the CPU chip, includes an internal memory.

The read/write controller 11 inputs a clock (Clock), a command signal (Command) and an address signal (Address) to the device 20 via the buses 2A, 2B and 2C of the circuit board 2, respectively.

The clock is a system clock of the electronic apparatus 1. The command signal is used for performing the write operation or the read operation. The address signal is used for designating an address of a memory cell in the device 20 when the write operation or the read operation is performed.

The read/write controller 11 inputs the clock, the command signal and the address signal to the device 20, and performs the write operation or the read operation in accordance with the command signal on the memory cell identified by the address signal. When the write operation or the read operation is performed, the data is transmitted via the bus 2D of the circuit board 2.

The trigger generator 12 generates a trigger signal which causes the oscilloscope 30 to start an observation process when waveforms of an output signal of the device 10 are observed by the oscilloscope 30.

The trigger generator 12 outputs the trigger signal (Trigger) based on the clock, the command signal and the address signal output from the read/write controller 11 when an internal control signal is input from the read/write controller 11. The trigger signal is output from the device 10 to the trigger signal terminal 2E of the circuit board 2.

The oscilloscope 30 is used when observing the command signal and the address signal output from the device 10 to the buses 2B and 2C and the data transmitted through the bus 2D between the devices 10 and 20.

For example, in a case where the oscilloscope 30 has four probes P1, P2, P3 and P4, the probes P1, P2, P3 and P4 are connected to the buses 2B, 2C and 2D and trigger signal terminal 2E, respectively. The probes P1, P2 and P3 are connected to vias, pins or the like that are formed on the buses 2B, 2C and 2D. Terminals may be provided on the buses 2B, 2C and 2D in order to connect the probes P1, P2 and P3 to the buses 2B, 2C and 2D.

It is possible to observe the waveforms of the command signal, the address signal and the data through the probes P1, P2 and P3 by observing waveforms input to the probes P1, P2, P3 when the trigger signal output to the trigger signal terminal 2E is detected through the probe P4 of the oscilloscope 30.

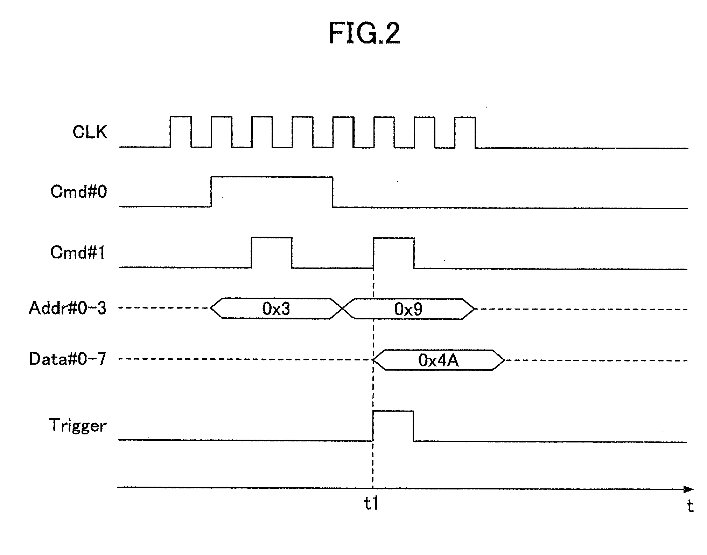

FIG. 2 is a diagram illustrating the waveforms of the signals obtained in the electronic apparatus 1 of the comparative example. In FIG. 2, the waveforms of the clock CLK, the two command signals Cmd#0 and Cmd#1, the four address signals Addr#0-3, the eight data Data#0-7 and the trigger signal Trigger are illustrated.

In FIG. 2, for example, the trigger generator 12 generates an H level pulse of the trigger signal Trigger with regard to address 0x9 when the command signal Cmd#1 transits from Low (L) level to High (H) level in a state where the command signal Cmd#0 is L level. The trigger signal Trigger is output to the trigger signal terminal 2E.

Accordingly, it is possible to observe the waveforms of the command signal, the address signal and the data obtained via the probes P1, P2 and P3 on the oscilloscope 30, if the observation is started when the trigger signal Trigger detected by the probe P4 is observed on the oscilloscope 30.

By the way, the trigger signal terminal 2E of the device 10 of the electronic apparatus 1 is used only when the observation of the clock (Clock), the command signal (Command), and the address signal (Address) transmitted through the buses 2B, 2C and 2D is performed.

Accordingly, the device 10 of the electronic apparatus 1 includes the trigger signal terminal 2E which is not used in a normal operating state. Herein, the normal operating state is a type of a state in which the electronic apparatus 1 performs a normal operation such as arithmetic operations or the like.

Accordingly, the device 10 of the comparative example has low utilization efficiency.

In the first to third embodiments, semiconductor circuit apparatuses and electronic apparatuses that have improved utilization efficiency will be described.

Hereinafter, the first to third embodiments to which the semiconductor circuit apparatus and the electronic apparatus of the present invention are applied will be described.

### <First embodiment>

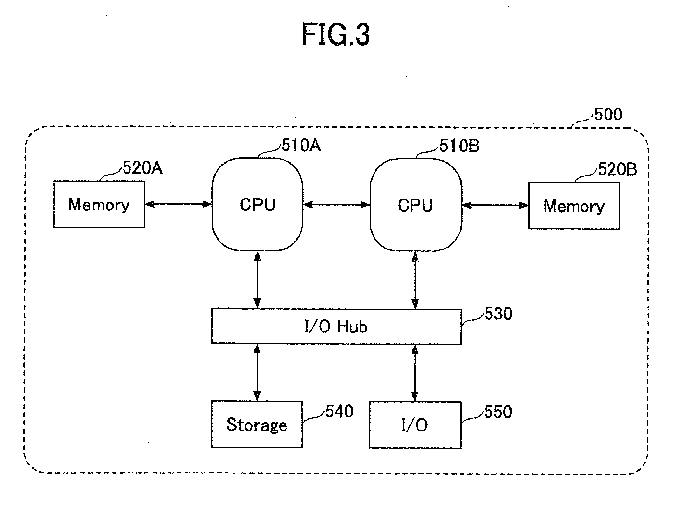

FIG. 3 is a diagram illustrating a server 500 including the semiconductor circuit apparatus and the electronic apparatus according to the first embodiment. The server 500 is one example of an information processing unit.

The server 500 includes CPUs 510A and 510B, memories 520A and 520B, an I/O hub 530, a storage 540 and an I/O 550.

The CPUs 510A, 510B are connected to the memories 520A and 520B, respectively. The CPUs 510A and 510B are connected to the storage 540 and the I/O 550 via the I/O hub 530.

The CPUs 510A and 510B are so-called CPU chips, respectively. The memories 520A and 520B are NAND flash memories, respectively, for example. The I/O hub 530 is an integrated circuit which is disposed between the CPUs 510A and 510B and the storage 540 and the I/O 550. The I/O hub 530 may be included in the CPUs 510A and 510B.

The storage 540 is a Hard Disk Drive (HDD) or a Solid State Drive (SSD), for example. The I/O 550 is connected to a Local Area Network (LAN).

In the server 500 as described above, the electronic apparatus of the first embodiment is realized by the CPU 510A and the memory 520A, for example. In this case, the semiconductor circuit apparatus of the first embodiment is the CPU 510A.

Similarly, the electronic apparatus of the first embodiment may be realized by the CPU 510B and the memory 520B, for example. In this case, the semiconductor circuit apparatus of the first embodiment is the CPU 510B.

Moreover, the electronic apparatus of the first embodiment may be realized by the CPUs 510A and 510B, for example. In this case, the semiconductor circuit apparatus of the first embodiment is the CPUs 510A and 510B.

Further, the electronic apparatus of the first embodiment may be realized by the CPU 510A and the I/O hub 530, for example. In this case, the semiconductor circuit apparatus of the first embodiment is the CPU 510A. Further, the electronic apparatus of the first embodiment may be realized by the CPU 510B and the I/O hub 530, for example.

Further, the electronic apparatus of the first embodiment may be realized by the I/O hub 530 and the storage 540, for example. In this case, the semiconductor circuit apparatus of the first embodiment is the I/O hub 530.

Furthermore, the electronic apparatus of the first embodiment may be realized by the I/O hub 530 and the I/O 550, for example. In this case, the semiconductor circuit apparatus of the first embodiment is the I/O hub 530.

As described above, the semiconductor circuit apparatus and the electronic apparatus of the first embodiment may be applied to various parts of the server 500. Hereinafter, an embodiment in which the semiconductor circuit apparatus and the electronic apparatus of the first embodiment are applied to the server 500 will be described. However, the semiconductor circuit apparatus and the electronic apparatus of the first embodiment may be applied to a device or an apparatus other than the server 500 as long as data is transmitted within the device or the apparatus.

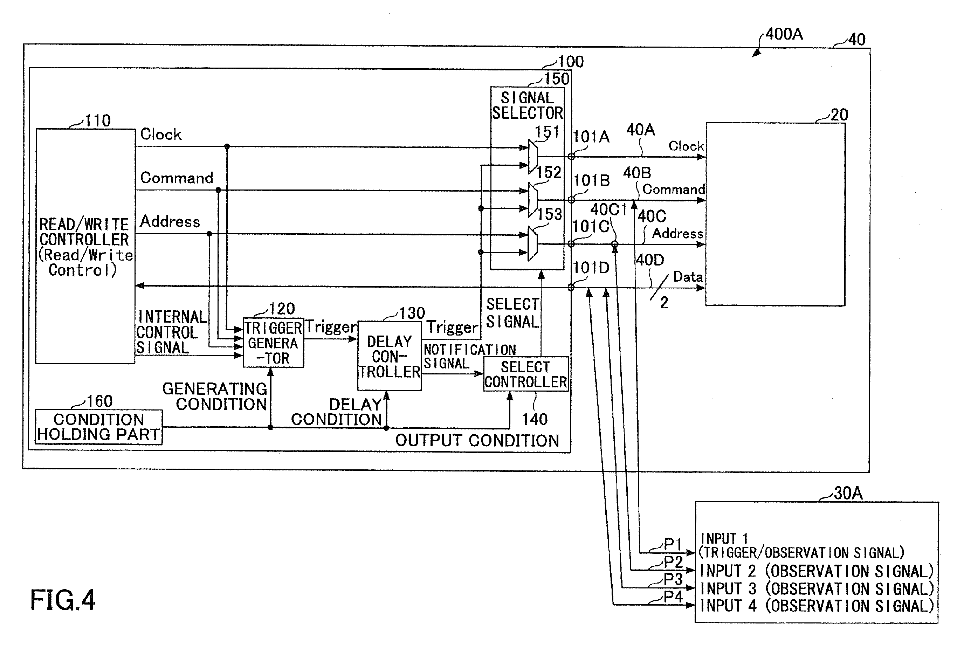

In the following, an electronic apparatus 400A including a device 100 of the first embodiment will be described with reference to FIG. 4.

FIG. 4 is a diagram illustrating the electronic apparatus 400A including the device 100 of the first embodiment.

The electronic apparatus 400A includes the device 100, a device 20 and a circuit board 40. FIG. 4 illustrates a state where an oscilloscope 30A is connected to the electronic apparatus 400A.

The device 100 is a part of the server 500. The devices 100 and 20 are made by utilizing a semiconductor manufacturing technique, respectively, for example.

More precisely, the device 100 is a part or all of the CPU 510A or 510B of the server 500 (see FIG. 3) and performs a control operation which is necessary for an operation of the server 500, for example. In this case, the device 20 is the memory 520A or 520B (see FIG. 3) storing the data, for example.

The device 100 is one example of a semiconductor circuit apparatus. Herein, an embodiment in which the device 100 performs the control operation will be described. However, the device 100 may be a circuit which performs data processing such as arithmetic operations or the like. Otherwise, the device 100 may be a semiconductor circuit apparatus which does not perform the control operation or the data processing such as the arithmetic operation or the like. Further, the device 100 may be a semiconductor circuit apparatus such as the I/O hub 530 (see FIG. 3) of the server 500 which transmits the data, for example.

The device 20 is one example of a second semiconductor circuit apparatus and is similar to the device 20 of the comparative example. Herein, an embodiment in which the device 20 is a memory will be described. However the device 20 may be a circuit other than the memory. For example, the device 20 may not be a circuit such as memory but may be a circuit such as the I/O hub 530 which transmits the data to the device 100. Further, the device 20 may be a circuit which performs the data processing such as the arithmetic operation or the control operation or the like.

Hereinafter, in the first embodiment, a case where the device 100 corresponding to all or a part of the CPU 510A (see FIG. 3) performs write operations or read operations of the data to or from the device 20 corresponding to the memory 520A (FIG. 3) will be described.

The circuit board 40 is an FR-4 (Flame Retardant type 4) standardized multi-layer printed circuit board, for example. The devices 100 and 20 are mounted on the circuit board 40. The circuit board 40 is a so-called mother board. The circuit board 40 includes buses 40A, 40B, 40C and 40D. The circuit board 40 includes another bus, traces, a power source layer(s) and a grounded layer(s) or the like that are formed on a top surface and a bottom surface and formed in an inner layer of the circuit board 40, in addition to the buses 40A, 40B, 40C and 40D.

Although, a probe terminal 40C1 is disposed on the bus 40C in FIG. 4, similar probe terminal(s) may be disposed on any of the buses 40A, 40B and 40D.

The device 100 includes a read/write controller (Read/Write Control) 110, a trigger generator 120, a delay controller 130, a select controller 140, a signal selector 150, a condition holding part 160 and terminals 101A, 101B, 101C and 101D.

The device 100 performs the write operation of the data to the device 20 and the read operation of the data written in the device 20.

The terminals 101A, 101B, 101C and 101D are connected to the buses 40A, 40B, 40C and 40D of the circuit board 40, respectively. The terminals 101A, 101B and 101C output a clock (Clock), a command signal (Command) and an address signal (Address), respectively. Each of the terminals 101A, 101B and 101C is one example of an outputting part.

The terminal 101D inputs and outputs the data (Data).

For the purpose of illustration, in FIG. 4, the terminals 101A, 101B, 101C, 101D are illustrated one by one.

However, in a case where the device 100 outputs a plurality of the clocks, the device 100 includes a plurality of the terminals 101A. In this case, number of the terminals 101A corresponds to number of the clocks. However, in a case where the device 100 outputs a plurality of the command signals, the device 100 includes a plurality of the terminals 101B. In this case, number of the terminals 101B corresponds to number of the command signals.

However, in a case where the device 100 outputs a plurality of the address signals, the device 100 includes a plurality of the terminals 101C. In this case, the number of the terminals 101C corresponds to the number of the address signals. However, in a case where the device 100 outputs a plurality of the data, the device 100 includes a plurality of the terminals 101D. In this case, the number of the terminals 101D corresponds to the number of the data.

The number of the buses 40A, 40B, 40C and 40D corresponds to the number of the terminals 101A, 101B, 101C and 101D, respectively.

In FIG. 4, the probes P1 and P2 of the oscilloscope 30A are connected to the buses 40B and 40C, respectively. The two buses 40D are provided in the circuit board 40. The probes P3 and P4 of the oscilloscope 30A are connected to the two buses 40D, respectively.

The read/write controller 110 outputs the clock (Clock), the command signal (Command) and the address signal (Address) in order to perform the write operation or the read operation. The read/write controller 110 is one example of a controller.

The clock, the command signal and the address signal are output from the read/write controller 110 and are input to the buses 40A, 40B and 40C of the circuit board 40, respectively, via the signal selector 150 in the normal operating state.

In the normal operating state, the read/write controller 110 inputs the clock, the command signal and the address signal to the device 20 via the buses 40A, 40B and 40C and performs the write operation or the read operation. The data is transmitted via the bus 40D between the devices 100 and 20.

Herein, the normal operating state is a type of a state in which the device 100 performs a normal operation such as data processing or the like. More precisely, the normal operating state is an operating state of the device 100 other than an observation operating state in which the device 100 performs a waveform observation. The observation operating state is a state in which the device 100 performs an observation operation. In the observation operation, the device 100 outputs a signal which is used for starting an observation on the oscilloscope 30A.

When the device 100 performs the normal operation, the electronic apparatus 400A performs the normal operation. When the device 100 performs the observation operation, the electronic apparatus 400A performs the observation operation.

The clock, the command signal and the address signal output from the read/write controller 110 are input to the trigger generator 120 in the normal operating state and the observation operating state.

The clock is a system clock of the electronic apparatus 400A. The command signal is used for performing the write operation or the read operation. The address signal is used for designating an address of a memory cell in the device 20 when the write operation or the read operation is performed.

The read/write controller 110 inputs the clock, the command signal and the address signal to the device 20, and performs the write operation or the read operation in accordance with the command signal to the memory cell identified by the address signal. When the write operation and the read operation is performed, the data is transmitted via the bus 40D of the circuit board 40.

The trigger generator 120 outputs the trigger signal (Trigger) based on a generating condition input from the condition holding part 160 and the clock, the command signal and the address signal output from the read/write controller 110 when an internal control signal is input from the read/write controller 110. The trigger generator 120 is one example of a trigger signal generator.

The trigger generator 120 generates the trigger signal, if the trigger generator 120 determines that the clock, the command signal and the address signal output from the read/write controller 110 satisfy the generating condition output from the condition holding part 160.

The internal control signal is input from the read/write controller 110 to the trigger generator 120 when the observation operation is started. For example, the read/write controller 110 outputs the internal control signal in a case where a count value of a time-out timer becomes greater than a half value of a count value of time-out when the server 500 (see FIG. 3) is starting up. The time-out timer monitors the time-out of a request transmission operation.

Herein, an embodiment will be described in which the trigger generator 120 generates the trigger signal (Trigger) when the internal control signal is input from the read/write controller 110 to the trigger generator 120, and the trigger generator 120 determines that the generating condition is satisfied.

However, in the device 100 of the first embodiment, the internal control signal may not be used. Further, the internal control signal may be used in a manner different from a manner as described above. For example, the trigger generator 120 may determine if the generating condition is satisfied before the internal control signal is input to the trigger generator 120, and the trigger generator 120 may be prevented from outputting the trigger signal until the internal control signal is input to the trigger generator 120.

The trigger signal is used as a trigger for starting the observation operation in a case where the waveforms of the output signals of the device 100 are observed by the oscilloscope 30A. The trigger signal generated by the trigger generator 120 is input to the delay controller 130.

The trigger signal is output to the bus 40A, 40B or 40C via the delay controller 130, the signal selector 150 and terminal 101A, 101B or 101C in the observation operating state. The details of the trigger signal will be described hereinafter.

The delay controller 130 gives a delay period to the trigger signal output from the trigger generator 120 and outputs the delayed trigger signal to the signal selector 150. The delay controller 130 controls the delay period based on the delay condition input from the condition holding part 160. The delay controller 130 outputs a notification signal to the select controller 140 when the delay controller 130 outputs the delayed trigger signal. The notification signal represents that the controller 130 outputs the delayed trigger signal.

The select controller 140 generates a select signal based on the output condition input from the condition holding part 160 when the notification signal is input from the delay controller 130 in the observation operating state, and outputs the select signal to the signal selector 150.

The select signal is used for causing the signal selector 150 to select the trigger signal instead of at least one of the clock, the command signal and the address signal output from the read/write controller 110.

The signal selector 150 includes multiplexers 151, 152 and 153. The clock, the command signal and the address signal are output from the read/write controller 110 and input to the multiplexers 151, 152 and 153, respectively. The clock is input to one of two input terminals of the multiplexer 151. The command signal is input to one of two input terminals of the multiplexer 152. The address signal is input to one of two input terminals of the multiplexer 153. The delayed trigger signal output from the delay controller 130 is input to the other input terminals of the multiplexers 151, 152 and 153.

The select signal is output from the select controller 140 and input to select signal input terminals of the multiplexers 151, 152 and 153. The multiplexer 151 selects one of the clock and the trigger signal in accordance with the select signal and outputs the selected signal. The multiplexer 152 selects one of the command signal and the trigger signal in accordance with the select signal and outputs the selected signal. The multiplexer 153 selects one of the address signal and the trigger signal in accordance with the select signal and outputs the selected signal.

In a case where the device includes a plurality of the terminals 101A, the device 100 includes the same number of multiplexers 151 as that of the terminals 101A. The same applies to a combination of terminal 101B and multiplexer 152 and a combination of terminal 101C and multiplexer 153.

The select controller 140 and the signal selector 150, as a whole, are one example of a selector. The select controller 140 is one example of a select controller included in the selector, and the signal selector 150 is one example of a selecting circuit included in the selector.

The condition holding part 160 holds the generating condition, the delay condition and the output condition of the trigger signal. The condition holding part 160 may be a volatile memory such as a register, for example.

The generating condition, the delay condition and the output condition are set by a user of the device 100 when the device 100 is turned on.

The generating condition is used for defining a condition for generating the trigger signal. The device 100 generates the trigger signal when at least one of the clock, the command signal and the address signal is not output, and outputs the trigger signal instead of at least one of the clock, the command signal and the address signal from corresponding terminal(s) among the terminals 101A, 101B and 101C.

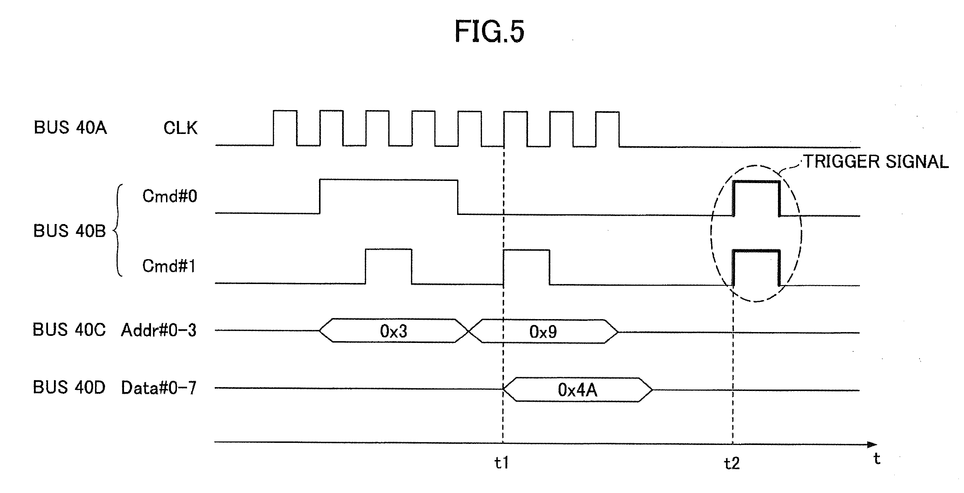

The generating condition is used for defining a start condition for generating the trigger signal based on the signal level of the clock, the command signal or the address signal. The generating condition will be described hereinafter with reference to FIG. 5.

The delay condition is used for defining a condition representing the delay period given to the trigger signal generated by the trigger generator 120. The device 100 outputs the trigger signal(s) instead of at least one of the clock, the command signal and the address signal from corresponding terminal(s) among the terminals 101A, 101B and 101C when at least one of the clock, the command signal and the address signal are not output.

Therefore, the delay condition represents the delay period which is given to the trigger signal generated by the trigger generator 120 so that the trigger signal is not output until a time point when the clock, the command signal or the address signal is not output from the read/write controller 110.

The output condition is used for determining at least one signal among the clock, the command signal and the address signal instead of which the delayed trigger signal is to be output.

In a case where the output condition represents that the delayed trigger signal is to be output instead of the clock, the select signal which causes the multiplexer 151 of the signal selector 150 to select the delayed trigger signal to be output from the delay controller 130 is input to the multiplexer 151.

In a case where the output condition represents that the delayed trigger signal is output instead of the command signal, the select signal which causes the multiplexer 152 of the signal selector 150 to select the delayed trigger signal output from the delay controller 130 is input to the multiplexer 152.

In a case where the output condition represents that the delayed trigger signal is to be output instead of the address signal, the select signal which causes the multiplexer 153 of the signal selector 150 to select the delayed trigger signal to be output from the delay controller 130 is input to the multiplexer 153.

In a case where the output condition represents that the delayed trigger signal is to be output instead of more than two signals among the clock, the command signal and the address signal, the select signals which cause corresponding multiplexers among the multiplexers 151 to 153 to select the delayed trigger signal to be output from the delay controller 130 are input to the corresponding multiplexers.

Although, an embodiment in which the condition holding part 160 holds the generating condition, the delay condition and the output condition is described, the delay condition may be included in the output condition. In this case, the condition holding part 160 holds the generating condition and the output condition which includes the delay condition.

In the following, an operation of the device 100 in the observation operating state will be described with reference to FIG. 5.

FIG. 5 is a timing diagram illustrating the waveforms of the signals output from the device 100 of the first embodiment.

FIG. 5 illustrates the signals output from the terminal 101A, 101B, 101C and 101D to the buses 40A, 40B, 40C and 40D. The device 100 outputs a clock CLK, two command signals Cmd#0 and Cmd#1 and four address signals Addr#0-3 from the terminals 101A, 101B, 101C and 101D to the buses 40A, 40B, 40C and 40D, and inputs or outputs eight data Data#0-7 in the normal operating state.

This corresponds to a state where the device 100 includes the two terminals 101B, the two multiplexers 152, the two buses 40B the four terminals 101C, the four multiplexers 153 and the four buses 40C (see FIG. 4). Further, the device 100 includes the eight buses 40D that transmit data.

In FIG. 5, the signals output from the two terminals 101B are illustrated separately.

In FIG. 5, names of the signals that are output from the terminal 101A, 101B, 101C and 101D to the buses 40A, 40B, 40C and 40D in the normal operating state are illustrated as well.

Herein, for example, the generating condition of the trigger signal is satisfied when the command signal Cmd#1 transits from L level to H level in a state where the command signal Cmd#0 is L level, with regard to the address 0x9.

The trigger generator 120 determines if the generating condition is satisfied based on the clock, the command signal and the address signal output from the read/write controller 110.

If the trigger generator 120 determines that the internal control signal is input from the read/write controller 110 and the generating condition is satisfied, the two multiplexers 152 of the signal selector 150 output the trigger signals to the two buses 40B instead of the command signals Cmd#0 and Cmd#1.

The trigger generator 120 outputs two pulses having H level over one clock cycle and rising at the same time as the trigger signals instead of the two command signals Cmd#0 and Cmd#1 based on the generating condition held at the condition holding part 160. The trigger signals constituted by the two pulses having H level over one clock cycle and rising at the same time are delayed at the delay controller 130, selected at the two multiplexers 152 and output from the two terminals 101B to the two buses 40B, respectively.

Herein, there is no operation pattern in which the command signals Cmd#0 and Cmd#1 transit from L level to H level over one clock cycle at the same time in a transmission protocol utilizing the command signals Cmd#0 and Cmd#1.

In the first embodiment, the device 100 generates the two trigger signals having a signal pattern that does not exist in the transmission protocol utilized in the device 100, and outputs the two trigger signals to the two buses 40B.

The trigger signals generated by the trigger generator 120 based on the generating condition held at the condition holding part 160 have the signal pattern that does not exist in the transmission protocol utilized in the device 100 of the first embodiment. In other words, the trigger signals have the signal pattern which is invalid in the transmission protocol utilized in the device 100.

Signals that have the invalid signal pattern in the transmission protocol utilized in the device 100 are used as the trigger signal. Since there are no signals having the same pattern as that of the trigger signal, it becomes possible to distinguish the trigger signal when the waveforms are observed by the oscilloscope 30A.

As a result, it is possible to observe the four signals that are transmitted through the buses 40B and 40C and the two buses 40D via the probes P1, P2, P3 and P4 and to observe the four signals on the oscilloscope 30A.

The delay period which is given to the trigger signal by the delay controller 130 based on the delay condition held at the condition holding part 160 represents a period of time between a point of time when the trigger generator 120 determines the satisfaction of the generating condition and the point of time when the trigger signal is output.

The reason why the delay period is determined as described above is to avoid collisions of the trigger signals and the command signals when the trigger signals are output from the two terminals 101B to the two buses 40B and to wait a timing at which there are no command signals on the two buses 40B. Accordingly, the delay period as described above is given to the trigger signals.

Since timings at which the clock, the command signal and the address signal are output are defined and known depending on variety of the transmission protocol, the trigger signals are delayed and output at the timing when there are no command signals on the buses 40B.

In FIG. 5, with regard to the address 0x9, a period of time from a time t1 at which the command signal Cmd#1 transits from L level to H level in a state where the command signal Cmd#0 is L level to time t2 at which the trigger signals are output to the buses 40B corresponds to the delay period which is given to the trigger signals.

A time t2, there are no command signals Cmd#0 and Cmd#1 on the buses 40B, and there are two pulses having H level over one clock cycle instead of the command signals Cmd#0 and Cmd#1 on the two buses 40B.

The operation pattern in which the two pulses having H level over one clock cycle at the same time does not exist in the transmission protocol which utilizes the command signals Cmd#0 and Cmd#1 on the two buses 40B.

Accordingly, it is possible to start the waveform observation on the oscilloscope 30A by observing the two pulses that have the H level over one clock cycle and rise at the same time at time t2 on the oscilloscope 30A.

According to the embodiment as described above, a trigger signal is output at a timing which is delayed from a timing at which a Write command is transmitted. The oscilloscope 30A has a function according to which the oscilloscope 30A can trace back and display the waveform from a timing at which the Write command is transmitted. Accordingly, the delay does not matter at all.

According to the device 100 of the first embodiment, it is possible to output the trigger signal from the terminal 101B in the observation operating state from which the command signal is output in the normal operating state.

Therefore, it is not necessary to provide the terminal 10E which is used only for outputting the trigger signal as described with regard to the device 10 of the comparative example.

Accordingly, it is possible to provide the device 100 which has improved utilization efficiency according to the first embodiment.

As a result, it is possible to detect the trigger signal by at least one of the probes P1, P2, P3 and P4, to detect the four signals that are transmitted through the buses 40B and 40C and the two buses 40D via the probes P1, P2, P3 and P4 and to observe the four signals on the oscilloscope 30A.

This means that it is not necessary to provide a probe which is used only for detecting the trigger signal, and it becomes possible to increase the number of signals which can be observed by one.

Therefore, it is possible to provide the device 100 and the electronic apparatus 400A that have improved observation efficiency according to the first embodiment.

Although, an embodiment in which the trigger signal is output from the terminal 101B is described, the trigger signal may be output from the terminal 101A, 101C or 101D.

For example, the trigger signal may be output from the terminal 101A during a period of time in which the clock is not output. Otherwise, the trigger signal may be output from the terminal 101C during a period of time in which the address signal is not output. Further, the trigger signal may be output from the terminal 101D during a period of time in which the data is not input to the device 100 and output from the device 100.

The electronic apparatus 400A including the device 100 can observe the signal waveforms of the signals in a state where the device 100 is in an actual operation by connecting the probes P1 to P4 of the oscilloscope 30A to the buses 40A to 40D. It is possible to understand the operations of the device 100 and the electronic apparatus 400 by observing the waveforms of the signals when the device 100 and the electronic apparatus 400 are in an actual operation.

### <Second embodiment>

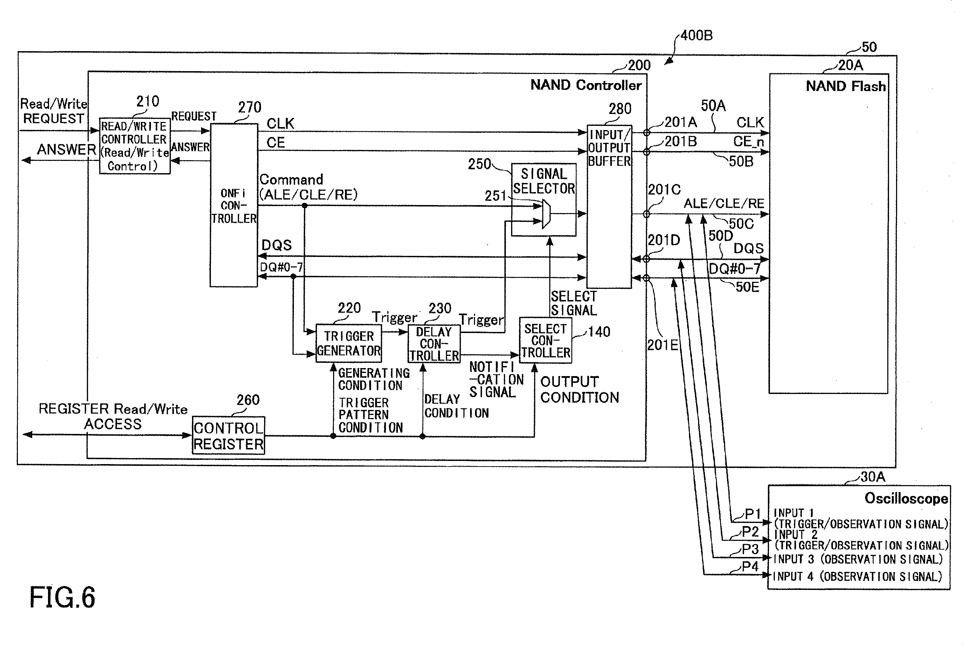

FIG. 6 is a diagram illustrating an electronic apparatus 400B including a device 200 of the second embodiment. The device 200 is a type of a device obtained by applying an Open NAND Flash interface (ONFi) protocol to the device 100 of the first embodiment. ONFi protocol is a standard of a NAND flash memory. Accordingly, the device 200 functions as a NAND controller.

The electronic apparatus 400B includes the device 200, a memory 20A and a circuit board 50. FIG. 6 illustrates a state where an oscilloscope 30A is connected to the electronic apparatus 400B.

The device 200 is a part of the server 500 (see FIG. 3). The device 200 and a memory 20A are made by utilizing a semiconductor manufacturing technique, respectively, for example. According to the second embodiment, the device 200 performs a control operation. The device 200 may be a semiconductor circuit apparatus which does not perform the control operation. This is similar to the device 100 of the first embodiment.

The memory 20A corresponds to the device 20 of the first embodiment, and is the NAND flash memory, for example, according to the second embodiment.

Hereinafter, the same elements as or elements similar to those of the device 100 of the first embodiment are referred to by the same reference numerals, and a description thereof is omitted.

The circuit board 50 is similar to the circuit board 40 of the first embodiment, and is an FR-4 standardized multi-layer printed circuit board, for example. The device 200 and the memory 20A are mounted on the circuit board 50. The circuit board 50 is a so-called mother board. The circuit board 50 includes buses 50A, 50B, 50C, 50D and 50E. The circuit board 50 may include another bus, traces, a power source layer(s) and a grounded layer(s) or the like that are formed on a top surface and a bottom surface and formed in an inner layer of the circuit board 50, in addition to the buses 50A, 50B, 50C, 50D and 50E.

The device 200 includes a read/write controller (Read/Write Control) 210, a trigger generator 220, a delay controller 230, a select controller 140, a signal selector 250, a control register 260, an ONFi controller 270, an input/output buffer 280 and terminals 201A, 201B, 201C, 201D and 201E.

The device 200 performs a write operation of the data to the memory 20A and a read operation of the data written in the memory 20A. The device 200 is one example of a semiconductor circuit apparatus.

The terminals 201A, 201B, 201C, 201D and 201E are connected to buses 50A, 50B, 50C, 50D and 50E of the circuit board 50, respectively. The terminal 201A outputs a clock (Clock). The terminal 201B outputs a CE_n signal. The terminal 201C outputs command signals (an ALE signal, a CLE signal and an RE signal). The terminal 201D inputs and outputs a strobe signal DQS. The terminal 201E inputs and outputs a data DQ#0-7.

For the purpose of illustration, one terminal 201C is illustrated in FIG. 6. Since the command signals include the ALE signal, the CLE signal and the RE signal, and the ALE signal, the CLE signal and the RE signal are transmitted to the memory 20A independently, the device 200 includes the three terminals 201C in a practical manner. The circuit board 50 includes the three buses 50C corresponding to the three terminals 201C in a practical manner.

Moreover, the device 200 includes the three signal selectors 250 to which the command signals (the ALE signal, the CLE signal and the RE signal) are input, in a practical manner. Three outputs of the three signal selectors 250 are input to the input/output buffer 280, respectively.

The ONFi controller 270 outputs the command signals (the ALE signal, the CLE signal and the RE signal) to the trigger generator 220, independently. The number of the trigger generators 220 included in the device 200 is one.

Although, one terminal 201D is illustrated in FIG. 6, for the purpose of illustration, the device 200 includes two terminals 201D in a case where the strobe signal DQS is constituted of differential signals. The two terminals 201D are used for inputting and outputting a positive strobe signal DQS and a negative strobe signal DQS, respectively.

Although one terminal 201E is illustrated in FIG. 6, for the purpose of illustration, the device 200 includes eight terminals 201E corresponding to the eight bit data DQ#0-7, in a practical manner, according to the second embodiment.

In FIG. 6, probes P1 and P2 of the oscilloscope 30A are connected to two of the three buses 50C, respectively. Probes P3 and P4 of the oscilloscope 30A are connected to one of the two buses 50D and one of the eight buses 50E, respectively.

The read/write controller 210 transmits a request of the write operation or the read operation of the data to the ONFi controller 270, when the write operation or the read operation is requested by a higher-level device of the device 200. The read/write controller 210 transmits an answer signal including the data read from the memory 20A to the higher-level device.

The request of the write operation includes the data which is to be written into the memory 20A.

The ONFi controller 270 converts the request of the write operation or the read operation into a command in an ONFi protocol when the write operation or the read operation is requested by the read/write controller 210, and then outputs a chip enable signal (CE) and the command signals (the ALE signal, the CLE signal and the RE signal). The ONFi controller 270 outputs a clock (Clock).

The ONFi controller 270 converts the data included in the write operation into the eight bit data DQ#0-7 that is adapted to the ONFi protocol when the write operation is requested by the read/write controller 210.

The ONFi controller 270 outputs the strobe signal DQS when outputting the data DQ#0-7 that is to be written to the memory 20A in the write operation.

The ONFi controller 270 outputs the chip enable signal (CE) to the input/output buffer 280. The ONFi controller 270 outputs the command signals (the ALE signal, the CLE signal and the RE signal) to the signal selectors 250 and the trigger generator 220.

The strobe signal DQS and the data DQ#0-7 are transmitted between the ONFi controller 270 and the input/output buffer 280. The data DQ#0-7 is transmitted to the trigger generator 220 as well.

The read/write controller 210 and the ONFi controller 270, as a whole, is one example of a controller.

The ONFi controller 270 reads the data from the memory 20A via the input/output buffer 280 when the read operation is requested by the read/write controller 210. The data read from the memory 20A is transmitted to the trigger generator 220 as well.

The command signals (the ALE signal, the CLE signal and the RE signal) output from the ONFi controller 270 are transmitted to the buses 50C of the circuit board 50 via the signal selectors 250 in the normal operating state.

In the normal operating state, the read/write controller 210 requests the write operation or the read operation to the ONFi controller 270. Then the ONFi controller 270 outputs the command signals (the ALE signal, the CLE signal and the RE signal) to the memory 20A via the buses 50C and performs the write operation or the read operation. The strobe signal DQS and the data DQ#0-7 are transmitted between the device 200 and the memory 20A via the buses 50D and 50E of the circuit board 50, respectively.

Herein, the normal operating state is a type of a state in which the device 200 performs a normal operation such as data processing or the like. More precisely, the normal operating state is an operating state of the device 200 other than an observation operating state in which the device 200 performs a waveform observation. The observation operating state is a state in which the device 200 performs an observation operation. In the observation operation, the device 200 outputs a signal which is used for starting an observation on the oscilloscope 30A.

The ONFi controller 270 outputs the command signals (the ALE signal, the CLE signal and the RE signal) and the data DQ#0-7 to the trigger generator 220 in the normal operating state and the observation operating state.

The chip enable signal (CE) and the command signals (the ALE signal, the CLE signal and the RE signal) are defined in accordance with a specification of the ONFi.

The chip enable signal (CE) represents whether the buses 50C are valid or invalid. In a case where the CE signal is H level, the buses 50C are valid. Therefore, the device 200 can access the memory 20A. In a case where the CE signal is L level, the buses 50C are invalid. Therefore, the device 200 cannot access the memory 20A.

The CE signal is inverted at the input/output buffer 280 and the inverted CE_n signal is output from the input/output buffer 280. The CE_n signal is obtained by inverting signal levels of the CE signal.

The ALE signal included in the command signals is an address latch enable (Address Latch Enable) signal and is utilized for using the data DQ#0-7 as address data. In a case where the ALE signal is H level, the data DQ#0-7 is used as the address data.

The CLE signal included in the command signals is a command latch enable (Command Latch Enable) signal and is utilized for using the data DQ#0-7 as a command. In a case where the CLE signal is H level, the data DQ#0-7 is used as the command.

In a case where the ALE signal and the CLE signal are L levels, the data DQ#0-7 is used as data.

The RE signal included in the command signals is a read enable (Read Enable) signal and is used as a timing signal of the read operation. The RE signal becomes a toggle pattern signal which takes H level and L level repeatedly when the device 200 reads the data from the memory 20A, and is kept to L level when the device 200 writes the data to the memory 20A. The toggle pattern signal is a pulse signal.

The clock CLK is a system clock of the electronic apparatus 400B.

The trigger generator 220 generates a trigger signal (Trigger) based on the generating condition and a trigger pattern condition input from the control register 260 and the command signals and the data input from the ONFi controller 270. The trigger generator 220 is one example of a trigger signal generator.

The trigger generator 220 generates the trigger signal, if the trigger generator 220 determines that the command signals and the data output from the ONFi controller 270 satisfy the generating condition output from the condition holding part 260.

The trigger signal is used as a trigger for starting the observation operation in a case where the waveforms of the output signals of the device 200 are observed by the oscilloscope 30A. In a case where the trigger signal genearated by the trigger generator 220 is input to the delay controller 230, the delay controller 230 performs a delay process in which the delay controller 230 gives a delay period to the trigger signal.

The trigger signals are output to at least one of the buses 50C via the delay controller 230, the signal selectors 250 and the terminals 201C instead of the corresponding command signals in the observation operating state. The details of the trigger signal will be described hereinafter.

The delay controller 230 gives a delay period to the trigger signal output from the trigger generator 220 and outputs the delayed trigger signal to the signal selectors 250. The delay controller 230 controls the delay period based on the delay condition input from the control register 260. The delay controller 230 outputs a notification signal to the select controller 140 when the delay controller 130 outputs the delayed trigger signal. The notification signal represents that the controller 130 outputs the delayed trigger signal.

According to the second embodiment, the delay controller 230 gives the delay period corresponding to a period of time of ten cycles of the system clock to the trigger signal output from the trigger generator 220, and outputs the delayed trigger signal. The delay controller 230 may include ten Flip Flops (FFs) that are connected in series and operate in accordance with the system clock and give the delay period corresponding to the ten cycles period of time to the trigger signal.

Otherwise, the delay controller 230 may include a plurality of inverters and selectors connected in an alternating fashion between an input terminal and an output terminal of the delay controller 230, and control the delay period by selecting one of the selectors at which the trigger signal returns to the output terminal. The delay controller 230 as described above may give the delay period corresponding to the ten cycles period of time to the trigger signal.

The select controller 140 generates a select signal based on the output condition input from the control register 260, if the notification signal is input from the delay controller 230 in the observation operating state, and outputs the select signals to the signal selectors 250.

The select signals are used for causing the signal selectors 250 to select the trigger signals instead of the command signals output from the ONFi controller 270.

The signal selector 250 includes a multiplexer 251. Although, the one signal selector 250 is illustrated in FIG. 6, the device 200 includes the three signal selectors 250 corresponding to the command signals (the ALE signal, the CLE signal and the RE signal) in a practical manner as described above. Accordingly, each of the signal selectors 250 includes the multiplexer 251. One of the command signals output from the ONFi controller 270 is input to one of two input terminals of the multiplexer 251. In this manner, the ALE signal, the CLE signal and the RE signal are input to the three multiplexers 251, respectively. The delayed trigger signal output from the delay controller 230 is input to each of the other input terminals of the multiplexers 251.

The select signal is output from the select controller 140 and input to select signal input terminals of the multiplexers 251. The multiplexers 251 select the command signals input from the ONFi controller 270 or the delayed trigger signal delayed by the delay controller 230 in accordance with the select signals, and output the selected signals.

The device 200 includes the three signal selectors 250 in a practical manner as described above. The ALE signal, the CLE signal and the RE signal are input to the three signal selectors 250, respectively.

The select controller 140 and the signal selector 250, as a whole, are one example of a selector. The select controller 140 is one example of a select controller included in the selector, and the signal selector 250 is one example of a selecting circuit included in the selector.

The control register 260 includes an interface connected to an external computer and holds the generating condition, the trigger pattern condition, the delay condition and the output condition of the trigger signal. The control register 260 includes a volatile memory, for example.

The generating condition, trigger pattern condition, the delay condition and the output condition are set by a user of the device 200 when the device 200 is turned on.

The generating condition is used for defining a condition for generating the trigger signal. When at least one of the command signals is not output, the device 200 generates the trigger signal instead of the command signal(s) that is not output, and outputs the trigger signal from the terminal(s) 201C.

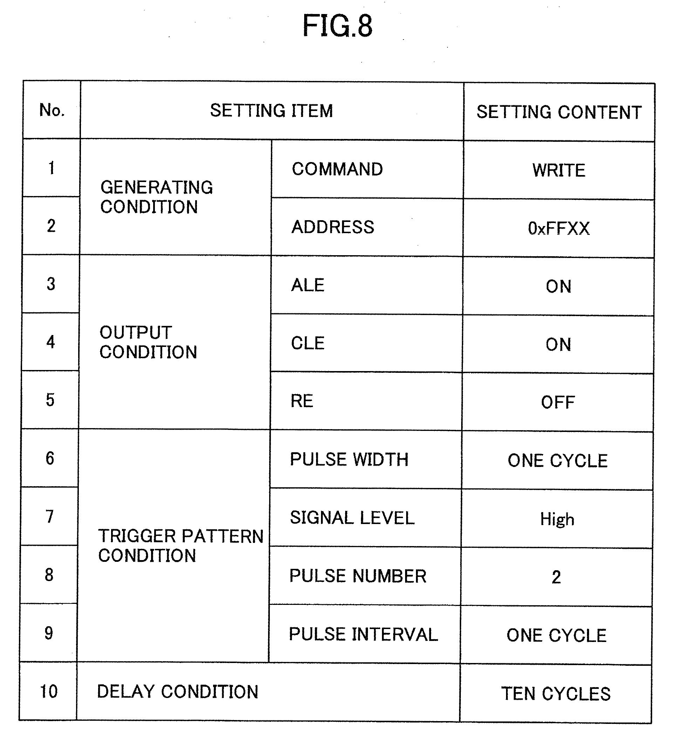

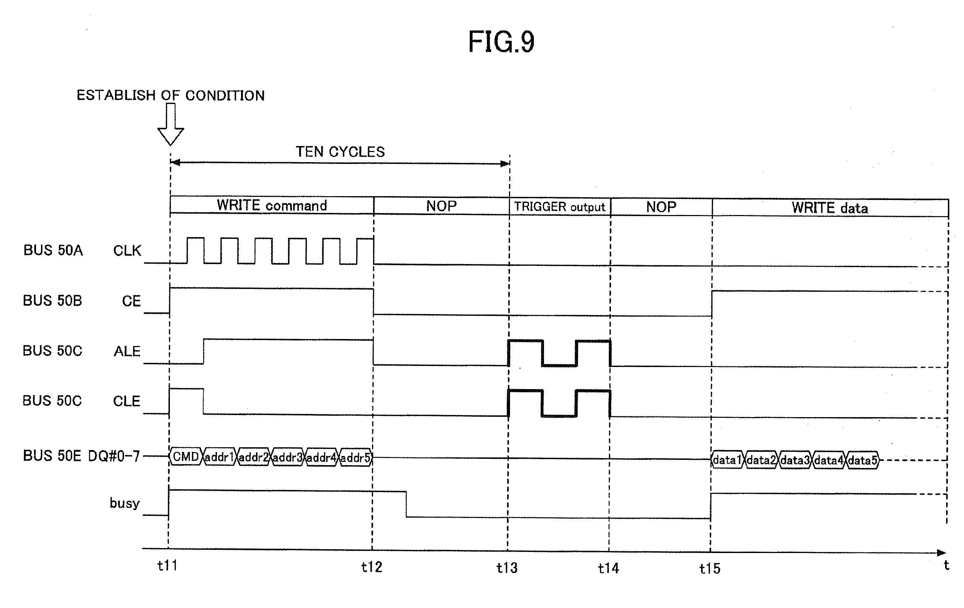

The generating condition is used for defining a start condition for generating the trigger signal based on signal patterns of the command signal(s) or the like. The generating condition will be described hereinafter with reference to FIGS. 8 and 9.

The trigger pattern condition represents a signal pattern of the trigger signal. The trigger pattern condition will be described hereinafter with reference to FIGS. 8 and 9.

The delay condition is used for defining a condition representing the delay period given to the trigger signal generated by the trigger generator 220. When at least one of the command signals is not output, the device 200 generates the trigger signal instead of the command signal(s) that is not output, and outputs the trigger signal from the terminal(s) 201C.

Therefore, the delay condition represents the delay period which is given to the trigger signal generated by the trigger generator 220 so that the trigger signal is not output until a point in time when at least one of the command signals does not output from the read/write controller 110.

The output condition is used for determining at least one signal among the ALE signal, the CLE signal and the RE signal instead of which the delayed trigger signal is to be output. Since the command signals include the ALE signal, the CLE signal and the RE signal, the output condition represents at least one signal among the ALE signal, the CLE signal and the RE signal instead of which the delayed trigger signal is to be output.

Accordingly, the output condition represents which output(s) of the three signal selectors 250 is to be switched to the trigger signal(s).

Although, an embodiment in which the control register 260 holds the generating condition, the trigger pattern condition, the delay condition and the output condition is described, the trigger pattern condition may be included in the generating condition. The delay condition may be included in the output condition. In this case, the control register 260 holds the generating condition including the trigger pattern condition and the output condition including the delay condition.

A user of the electronic apparatus 400B may write the generating condition, the delay condition and the output condition to the control register 260 via a Basic Input Output System (BIOS) or a debug Operating System (OS) before the storage 540 (see FIG. 3) starts operations when the device 200 is turned on.

The clock and the chip enable signal output from the ONFi controller 270 and the command signal(s) and/or the trigger signals output from the signal selectors 250 are input to the input/output buffer 280. The input/output buffer 280 transmits the data between the ONFi controller 270 and the memory 20A.

The input/output buffer 280 performs amplification and waveform shaping to the clock, the chip enable signal, the command signal, the trigger signal and data.

The terminal 201A is connected to the bus 50A, and outputs the clock input from the input/output buffer 280 to the bus 50A.

The terminal 201B is connected to the bus 50B, and outputs the inverted chip enable signal input from the input/output buffer 280 to the bus 50B.

The terminals 201C are connected to the buses 50C, and output the command signal(s) and/or the trigger signal(s) input from the input/output buffer 280 to the buses 50C.

The terminal 201D is connected to the bus 50D, and transmits the strobe signal DQS between the input/output buffer 280 and the bus 50D.

The terminal 201E is connected to the bus 50E, and transmits the data DQ#0-7 between the input/output buffer 280 and the bus 50E.

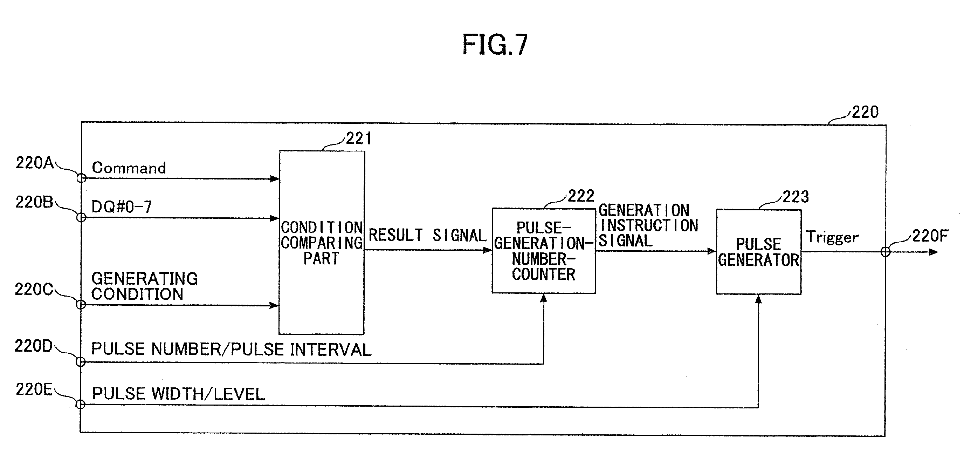

Hereinafter, details of the trigger generator 220 will be described with reference to FIG. 7.

FIG. 7 is a diagram illustrating the trigger generator 220.

The trigger generator 220 includes terminals 220A, 220B, 220C, 220D, 220E and 220F, a condition comparing part 221, a pulse-generation-number-counter 222 and a pulse generator 223.

The terminal 220A is connected to the ONFi controller 270. The command signals (the ALE signal, the CLE signal and the RE signal) are input to the terminal 220A. The terminal 220A inputs the command signals to the condition comparing part 221. Since the command signals include the ALE signal, the CLE signal and the RE signal, the trigger generator 220 includes the three terminals 220A in a practical manner.

The terminal 220B is connected to the ONFi controller 270. The data DQ#0-7 is input to the terminal 220B. The terminal 220B inputs the data DQ#0-7 to the condition comparing part 221. Since there are the eight data DQ#0-7, the trigger generator 220 includes eight terminals 220B in a practical manner.

The terminal 220C is connected to the control register 260. A signal representing the generating condition is input to the terminal 220C. The terminal 220C inputs a signal representing the generating condition to the condition comparing part 221.

The terminal 220D is connected to the control register 260. Data representing pulse number and pulse interval that are included in the trigger pattern condition is input to the terminal 220D. The terminal 220D inputs the data representing the pulse number and the pulse interval that are included in the trigger pattern condition to the pulse-generation-number-counter 222.

The terminal 220E is connected to the control register 260. Data representing a pulse width and a signal level of the pulse that are included in the trigger pattern condition is input to the terminal 220E. The terminal 220E inputs the data representing the pulse width and the signal level of the pulse that are included in the trigger pattern condition to the pulse generator 223.

The terminal 220F is connected to an output terminal of the pulse generator 223. The terminal 220F outputs the trigger signal (Trigger) generated by the pulse generator 223 to the delay controller 230 (see FIG. 6).

The condition comparing part 221 compares the ALE signal and the CLE signal included in the command signals and the data DQ#0-7 with the signal representing the generating condition. The condition comparing part 221 determines if the ALE signal, the CLE signal and the data DQ#0-7 satisfy the generating condition.

The condition comparing part 221 transmits a result signal representing the satisfaction of the generating condition if the condition comparing part 221 determines that the ALE signal, the CLE signal and the data DQ#0-7 satisfy the generating condition. H level of the result signal represents that the generating condition is satisfied. L level of the result signal represents that the generating condition is not satisfied.

The condition comparing part 221 as described above can be realized by a plurality of comparators that compare each of the ALE signal, the CLE signal and the data DQ#0-7 with the signal representing the generating condition, for example.

If the H level result signal is input to the pulse-generation-number-counter 222 from the condition comparing part 221, the pulse-generation-number-counter 222 outputs generation instruction signals at an interval equal to the pulse interval included in the trigger pattern condition. The number of the generation instruction signals is equal to the pulse number included in the trigger pattern condition. The pulse-generation-number-counter 222 outputs the generation instruction signals to the pulse generator 223.

If the generation instruction signal is input to the pulse generator 223 from the pulse-generation-number-counter 222, the pulse generator 223 generates a pulse signal as the trigger signal having the pulse width and the signal level based on the data included in the trigger pattern condition. The pulse generator 223 outputs the trigger signal to the terminal 220F. Since the terminal 220F is connected to the delay controller 230 (see FIG. 6), the trigger signal is input to the delay controller 230.

In the following, the generating condition, the output condition, the trigger pattern condition and the delay condition that are set in the control register 260 will be described with reference to FIG. 8.

FIG. 8 is a diagram illustrating table data representing the generating condition, the output condition, the trigger pattern condition and the delay condition that are set in the control register 260.

As illustrated in FIG. 8, the control register 260 stores the table data representing the generating condition, the output condition, the trigger pattern condition and the delay condition.

The generating condition includes commands and addresses. In a case where the command is the write operation (WRITE) command and the address is OxFFXX, the generating condition is satisfied. The write operation is equal to a so-called program operation. If the write operation command (WRITE) is issued to the address OxFFXX, the generating condition is satisfied.

The write operation command (WRITE) is represented as the L level ALE signal, the H level CLE signal and the DQ#0-7 signals having values of 0x80. Although details of a read operation command (READ) are not described in the present embodiment, the read operation command (READ) is represented as the L level ALE signal, the H level CLE signal and the DQ#0-7 signals having values of 0x00.

The output condition represents at least one signal among the ALE signal, the CLE signal and the RE signal instead of which the delayed trigger signal is to be output.

The output condition includes the ALE signal, the CLE signal and the RE signal. In FIG. 8, the ALE signal is ON, the CLE signal is ON and the RE signal is OFF. This represents that the trigger signals are output instead of the ALE signal and the CLE signal, and the RE signal is not output in the observation operating state.

In other words, in a case where the output condition represents that the ALE signal is ON, the CLE signal is ON and the RE signal is OFF, the select controller 140 outputs the select signals that causes the signal selectors 250 corresponding to the ALE signal and the CLE signal to output the trigger signals. In this case, the RE signal is not output from the signal selector 250.

The reason why the RE signal is not output in the observation operating state is that the RE signal is not treated as an observation object and that the bus 40B corresponding to the RE signal is not connected to the oscilloscope 30A in this operational example. The RE signal is not used as a trigger.

The trigger pattern condition includes the pulse width, the signal level, the pulse number and the pulse interval of the trigger signal(s). The pulse width represents a width of the pulse of the trigger signal. The signal level represents the signal level (H or L level) of the trigger signal. The pulse number represents a number of the pulses of the trigger signal. In other words, the pulse number represents a repeat count of the trigger signal and a cycle number of the trigger signal. The pulse interval represents an interval between the pulses in a case where the trigger signal is constituted of a plurality of the pulses.

Since the trigger pattern condition, as illustrated in FIG. 8, represents that the pulse width is one cycle, the signal level is H level, the pulse number is two and the pulse interval is one cycle of the clock CLK, the trigger signals defined by the pulse width, the signal level, the pulse number and the pulse interval as described above are generated and output instead of the ALE signal and the CLE signal.

According to the ONFi protocol, i.e. the standard of the ONFi, a command which includes the H level ALE signal and the H level CLE signal at the same time is not defined.

Therefore, the command which is not defined in the ONFi protocol as described above is used as the trigger signal, according to the second embodiment.

The delay condition represents the delay period given to the trigger signal. The delay period is a period of time between a point of time when the trigger signal is generated and the point of time when the device 200 outputs the trigger signal. The trigger signal is generated right after the generating condition is satisfied. A time difference between the generation of the trigger signal and the satisfaction of the generating condition is less than one cycle of the trigger signal and is negligibly short.

In the following, an operation of the device 200 in the observation operating state will be described with reference to FIG. 9.

FIG. 9 is a timing diagram illustrating the waveforms of the signals output from the device 200 of the second embodiment.

FIG. 9 illustrates the signals output from the terminal 201A, 201B, 201C and 201E to the buses 50A, 50B, 50C and 50E.

In the normal operating state, the device 200 outputs the clock CLK, the chip enable signal (CE), the ALE signal, the CLE signal and the data DQ#0-7 from the terminals 201A, 201B, 201C and 201E to the buses 50A, 50B, 50C and 50E, respectively.

In FIG. 9, names of the signals that are output from the terminals 201A, 201B, 201C and 201E to the buses 50A, 50B, 50C, 50E in the normal operating state are illustrated as well.

Among those signals, the ALE signal, the CLE signal and the data DQ#0-7 are used for determining the satisfaction of the generating condition. The determination is performed by the trigger generator 220.

FIG. 9 illustrates two of the three buses 50C (see FIG. 6) that transmit the ALE signal and the CLE signal. A busy state "busy" indicates statuses of the two buses 50C. The H level busy state indicates that as least one of the ALE signal and the CLE signal is transmitted through two of the buses 50C. The L level busy state indicates that neither the ALE signal nor the CLE signal is transmitted through the buses 50C.

In FIG. 9, the operating states of the device 200 are indicated as "WRITE command", "NOP" (NO Operation), "outputting trigger" and "WRITE data". The "WRITE command" indicates that the device 200 is outputting the write operation command. The "NOP" indicates that the device 200 is not in operation. The "outputting trigger" indicates that the device 200 is outputting the trigger signal. The "WRITE data" indicates that the device 200 is writing the data into the memory 20A.

As illustrated in FIG. 9, at time t11, the ALE signal is L level and the CE signal and the CLE signal rise from L level to H level. According to the ONFi protocol, a combination of the L level ALE signal and the H level CLE signal means a command. Therefore, the data DQ#0-7 is treated as the command (CMD) during a period of time in which the ALE signal is L level and the CLE signal is H level.

At time t11, the busy state transits to H level because a transmission of the command is started.

Since the write operation (WRITE) command is issued at time t11, the generating condition of the trigger signal is satisfied.

In the ONFi protocol, the issue of the write operation (WRITE) command is completed within ten cycles of the clock CLK.

After time t11, the address to which the write operation (WRITE) command is issued is designated as addr1, addr2, addr3, addr4 and addr5 with respect to each cycle over five cycles of the clock CLK. The issue of the write operation (WRITE) command is completed by the end of the sixth cycle of the clock CLK. At time t12, which is the beginning of the seventh cycle, the operating state of the device 200 turns to "NOP". Accordingly, the clock CLK stops as well. At a time point which is one cycle after time t12, the busy state transits to L level.

In the ONFi protocol, an operation is not performed during a designated period of time after the completion of the issue of the write operation (WRITE) command and before the write operation is performed.

At time t13, which is ten cycles after time t11, the trigger signals are output to the two buses 50C corresponding to the ALE signal and the CLE signal. The time period of the ten cycles is the delay period which is set by the delay condition (see FIG. 8).

The trigger signals are output from the two terminals 202C (see FIG. 6) to the two buses 50C from time t13 to time t14, respectively. Time t14 is three cycles after time time t13.

The pattern of the trigger signals that are defined by the trigger pattern condition (see FIG. 8) is as follows. The pulse width is one cycle of the clock CLK. The signal level of the pulse is H level. The pulse number is two. The pulse interval is one cycle of the clock CLK.

Accordingly, the trigger signal according to the second embodiment is constituted by the two H level pulses having the pulse width of one cycle of the clock CLK and the pulse interval of one cycle of the clock CLK. The two H level pulses are output to the buses 50C that transmit the ALE signal and the CLE signal in the normal operating state. The two H level pulses are output during the period from time t13 to time t14 as illustrated in FIG. 9.

The signal pattern according to which the ALE signal and the CLE signal transit to H level at the same time is not defined in the ONFi protocol. Therefore, a false operation does not occur in the memory 20A, if the trigger signals having the signal pattern as described above are output to the buses 50C that transmit the ALE signal and the CLE signal in the normal operating state.

After time t15, data indicated as data1, data2, data3, data4 and data5 is written to the addresses indicated as addr1, addr2, addr3, addr4 and addr5, respectively. Time t15 is the designated period of time after the completion of the issue of the write operation (WRITE) command.

According to the second embodiment, the trigger signals having the signal pattern which does not exist in the ONFi protocol utilized in the device 200 are generated and output to the two buses 50C that transmit the ALE signal and the CLE signal in the normal operating state.

The trigger signals generated by the trigger generator 220 based on the generating condition held at the control register 260 have the signal pattern that does not exist in the ONFi protocol utilized in the device 200 of the second embodiment. In other words, the trigger signals have the signal pattern which is invalid in the ONFi protocol utilized in the device 200.

Therefore, the false operation does not occur in the memory 20A, if the trigger signals having the signal pattern as described above are output to the buses 50C that transmit the ALE signal and the CLE signal in the normal operating state.

Signals that have the invalid signal pattern in the ONFi protocol utilized in the device 200 are used as the trigger signals. Since there are no signals having the same pattern as that of the trigger signal, it becomes possible to distinguish the trigger signal when the waveforms are observed by the oscilloscope 30A.

As a result, in a case where the probes P1, P2, P3 and P4 of the oscilloscope 30A are connected to two of the buses 50C, one of the buses 50D and one of the buses 50E, as illustrated in FIG. 6, it is possible to observe the four signals transmitted through the four buses.

According to the device 200 of the second embodiment, it is possible to output the trigger signals from the two terminals 201C in the observation operating state from which the ALE signal and the CLE signal are output in the normal operating state. The trigger signals are output during the period of time, such as the period between time t12 and time t15, in which the ALE signal and the CLE signal are not transmitted through the two buses 50C.

Therefore, it is not necessary to provide the terminal 10E which is used only for outputting the trigger signal as described with regard to the device 10 of the comparative example.

Accordingly, it is possible to provide the device 200 which has improved utilization efficiency according to the second embodiment.

As a result, it is possible to detect the trigger signal by two of the probes P1, P2, P3 and P4, to detect the four signals that are transmitted through the two of the buses 50C, one of the buses 50D and one of the buses 50E via the probes P1, P2, P3 and P4 and to observe the four signals on the oscilloscope 30A.

Since the oscilloscope 30A can detect the trigger signals and start the observation operation, it is possible to observe waveforms of the ALE signal, the CLE signal, the strobe signal DQS and one of the data DQ#0-7 via the probes P1 to P4.

This means that it is not necessary to provide a probe which is used only for detecting the trigger signal, and it becomes possible to increase the number of signals which can be observed by one.

Therefore, it is possible to provide the device 200 and the electronic apparatus 400B that have improved observation efficiency according to the second embodiment.

According to the embodiment as described above, the trigger signals are output from the two terminals 201C instead of the ALE signal and the CLE signal during the period between time t13 to time t14. The two terminals 201C output the ALE signal and the CLE signal in the normal operating state, respectively. The trigger signals do not correspond to the commands defined in the ONFi protocol, and are invalid in the ONFi protocol.

However, the trigger signals as described above are illustrative only. It is possible to generate trigger signal(s) having a signal pattern which is not defined in the ONFi protocol by utilizing the CE signal, the ALE signal, the CLE signal, the RE signal or the like.

Although the embodiment in which the ONFi protocol is utilized is described, it is possible to generate the trigger signal in a case where the device 200 utilizes a protocol other than the ONFi protocol in a similar fashion. The trigger signal may be generated by utilizing a signal pattern(s) which is not defined as a command in the protocol.

Although the embodiment in which the busy state transits to L level at a point in time when one cycle period of the clock CLK has passed after time t12 is described, the timing at which the busy state transits to L level may be forwarded or delayed compared to the timing as described above in accordance with characteristics of the device 200 or the like.

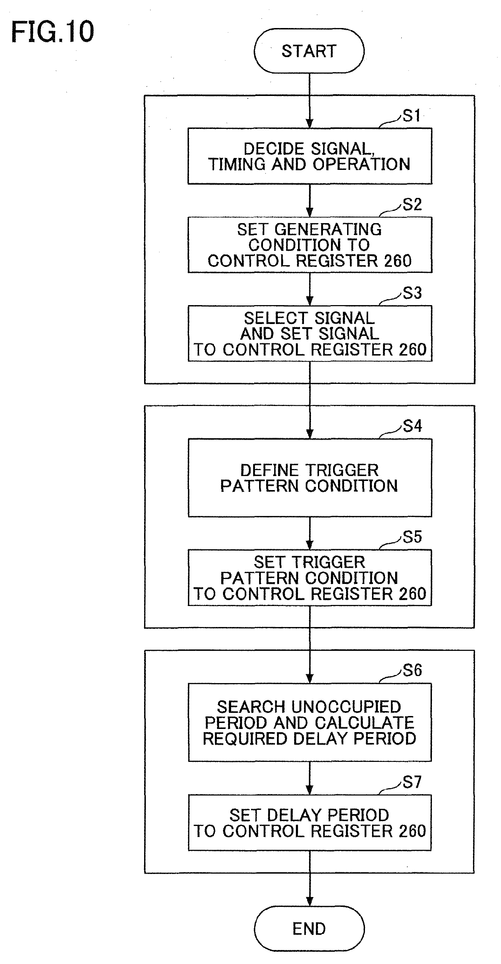

In the following, a process which is carried out by the user of the device 200 in order to determine the trigger signal will be described with reference to FIG. 10.

FIG. 10 is a diagram illustrating the process carried out by the user of the device 200 in order to determine the trigger signal.

At first, the user decides a signal, a timing and an operation of the device 200 that the user wants to observe at the oscilloscope 30A (step S1).

For example, the user may decide to observe the ALE signal, the CLE signal, the strobe signal DQS and one of the data DQ#0-7 when the device 200 performs the write operation and accesses to the address OxFFXX, as described above. The user may determine a signal, a timing and an operation of the device 200 that the user wants to observe at the oscilloscope 30A, as described above.

Next, the user sets the generating condition of the trigger signal to the control register 260 (step S2).

For example, the user may write the generating condition to the control register 260 via the BIOS or the debug OS before the storage 540 starts operations when the device 200 is turned on, as described above. The user may set the generating condition of the trigger signal to the control register 260 as described above.

Next, the user selects a signal instead of which the trigger signal is to be output, and sets the signal to the control register 260 as the output condition (step S3).

For example, the user may set the output condition so that the ALE signal and the CLE signal are selected and the RE signal is not selected, as described above. The user may set the output condition as described above.

Next, the user defines a signal pattern which does not exist in the transmission protocol as the trigger pattern condition (step S4).

For example, the user may find that the signal pattern in which the ALE signal and the CLE signal transit to H level does not exist in the ONFi protocol, and define the signal pattern as the trigger pattern condition as described above. The user may define the signal pattern which does not exist in the transmission protocol as the trigger pattern condition as described above.

Next, the user sets the trigger pattern condition defined at step S4 to the control register 260 (step S5).

For example, the user may set the signal pattern in which the ALE signal and the CLE signal transit to H level at the same time in the ONFi protocol to the control register 260 as the trigger pattern condition. The user may set the trigger pattern condition to the control register 260 as described above.

Next, the user searches for an unoccupied period of a bus through which the signal included in the trigger pattern condition is transmitted and calculates a required delay period (step S6).

For example, the user may find that the write operation command (WRITE) is completed within ten cycles of the clock CLK and that there is a designated unoccupied period before the start of the write operation. Therefore, the user may set the delay period to ten cycles of the clock CLK as described above. The user may calculate the delay period as described above.

Finally, the user sets the delay period calculated at step S6 to the control register 260 as the delay condition (step S7).

As a result, the table data as illustrated in FIG. 8 is obtained.

The user may decide the generating condition, the output condition, the trigger pattern condition and the delay condition and set them in the control register 260 as described above.

### <Third embodiment>

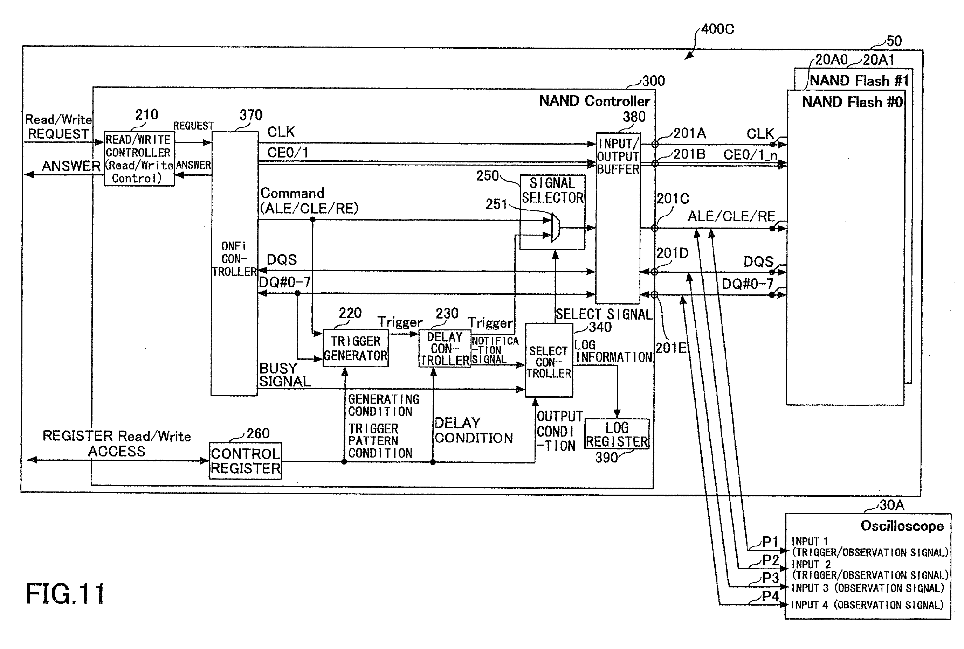

FIG. 11 is a diagram illustrating an electronic apparatus 400C including a device 300 of the third embodiment. Two memories 20A0 and 20A1 are connected to the device 300. In this point, the device 300 is different from the device 200. Each of the memories 20A0 and 20A1 is similar to the memory 20A of the second embodiment, and is constituted of a NAND flash memory.

Since the two memories 20A0 and 20A1 are connected to the device 300, the device 300 includes an ONFi controller 370, an input/output buffer 380 and a log register 390. Those are different from the configuration of the device 200 of the second embodiment.

Hereinafter, the same elements as or elements similar to those of the device 200 of the second embodiment are referred to by the same reference numerals, and a description thereof is omitted.

In a case where an issue frequency of the command is relatively high, for example, there may be a case in which it is not easy to obtain the unoccupied period of the buses 50C. For example, in a case where the two memories 20A0 and 20A1 are connected to two of the three buses 50C and the device 300 accesses the memories 20A0 and 20A1 in parallel, the issue frequency of the command may increase compared with that of the device 200. Accordingly, it may not be easy to obtain the unoccupied period of the buses 50C.

This tendency may become pronounced in a case where more than three memories are connected to the device 300. This is because the issue frequency of the command increases in proportion to the number of the memories connected in parallel.

The device 300 of the third embodiment is provided so that the user of the device 300 can comprehend the unoccupied period of the buses 50C by storing logs representing the unoccupied period to the log register 390.

The electronic apparatus 400C includes the device 300, the memories 20A0 and 20A1 and a circuit board 50. FIG. 11 illustrates a state where an oscilloscope 30A is connected to the electronic apparatus 400C.

The device 300 is a part of the server 500 (see FIG. 3). The device 300 and the memories 20A0 and 20A1 are made by utilizing a semiconductor manufacturing technique, respectively, for example. According to the third embodiment, the device 300 performs a control operation. The device 300 may be a semiconductor circuit apparatus which does not perform the control operation. This is similar to the devices 100 and 200 of the first and the second embodiments.

Each of the memories 20A0 and 20A1 is similar to the memory 20A of the second embodiment, and is constituted of the NAND flash memory.

The circuit board 50 is similar to the circuit board 50 of the second embodiment. In the third embodiment, the device 300 and the memories 20A0 and 20A1 are mounted on the circuit board 50. The memories 20A0 and 20A1 share the buses 50A and 50C to 50E. Accordingly, the memories 20A0 and 20A1 are connected to the buses 50A and 50C to 50E parallel to each other.

The device 300 includes a read/write controller (Read/Write Control) 210, a trigger generator 220, a delay controller 230, a select controller 340, a signal selector 250, a control register 260, the ONFi controller 370, the input/output buffer 380, the log register 390 and terminals 201A, 201B, 201C, 201D and 201E.

The device 300 performs a write operation of the data to the memories 20A0 and 20A1 and a read operation of the data written in the memories 20A0 and 20A1. The device 300 is one example of a semiconductor circuit apparatus.

The ONFi controller 370 outputs the command signals (the ALE signal, the CLE signal and the RE signal) to the trigger generator 220, independently. Number of the trigger generator 220 included in the device 300 is one.

The read/write controller 210 transmits a request of the write operation or the read operation of the data to the ONFi controller 370, when the write operation or the read operation are requested by a higher-level device of the device 300.

The write operations to the memories 20A0 and 20A1 are performed at different timings to each other. The read operations of the memories 20A0 and 20A1 are performed at different timings to each other as well.

The ONFi controller 370 converts the request of the write operation or the read operation into a command in an ONFi protocol when the write operation or the read operation are requested by the read/write controller 210, and then outputs a chip enable signal (CE) and the command signals (the ALE signal, the CLE signal and the RE signal).

The chip enable signals (CE0/1) include two chip enable signals (a CE0 signal and a CE1 signal). The CE0 signal and the CE1 signal represent whether the buses 50C are valid or invalid, respectively, when the device 300 performs the read operation or the write operation.

The ONFi controller 370 outputs the CE0 signal and the CE1 signal independently. The CE0 signal and the CE1 signal are transmitted through the input/output buffer 380 and output from the terminals 201B. The device 300 includes the two terminals 201B. Therefore the device 300 of the third embodiment includes the two buses 50B.

The CE0 signal and the CE1 signal represent whether the buses 50C are valid or invalid, respectively. In a case where the CE0 signal is H level, the buses 50C are valid. Therefore, the device 300 can access the memory 20A0. In a case where the CE0 signal is L level, the buses 50C are invalid. Therefore, the device 300 cannot access the memory 20A0.

In a case where the CE1 signal is H level, the buses 50C are valid. Therefore, the device 300 can access the memory 20A1. In a case where the CE1 signal is L level, the buses 50C are invalid. Therefore, the device 300 cannot access the memory 20A1.

The CE0 signal and the CE1 signal are inverted at the input/output buffer 380 and output as a CE0_n signal and a CE1_n signal. The inverted CE0_n signal and the inverted CE1_n signal may be referred to as signals CE0_/1_n.

The ONFi controller 370 outputs a busy signal. The busy signal represents statuses of the two buses 50C. The H level busy signal represents that at least one of the ALE signal and the CLE signal is transmitted through the corresponding bus(s) 50C. In other words, the busy signal represents that at least one of the ALE signal and the CLE signal is output from the corresponding terminal(s) 201C to the corresponding bus(s) 50C. The busy signal is one example of a notification signal.

The L level busy signal indicates that both of the ALE signal and the CLE signal are not transmitted through the buses 50C. The ONFi controller 370 outputs the busy signal to the select controller 340.

The ONFi controller 370 outputs a clock (Clock).

The ONFi controller 370 outputs the chip enable signals (CE0/1) to the input/output buffer 380. The ONFi controller 370 outputs the command signals (the ALE signal, the CLE signal and the RE signal) to the signal selectors 250 and the trigger generator 220.

The strobe signal DQS and the data DQ#0-7 are transmitted between the ONFi controller 370 and the input/output buffer 380. The data DQ#0-7 is transmitted to the trigger generator 220 as well.

The ONFi controller 370 reads the data from the memories 20A0 and 20A1 via the input/output buffer 380 when the read operation is requested by the read/write controller 210. The data read from the memories 20A0 and 20A1 is transmitted to the trigger generator 220 as well.

The command signals (the ALE signal, the CLE signal and the RE signal) output from the ONFi controller 370 are transmitted to the buses 50C of the circuit board 50 via the signal selectors 250 in the normal operating state.

In the normal operating state, the read/write controller 210 sends a request for the write operation or the read operation to the ONFi controller 370. Then the ONFi controller 370 outputs the command signals (the ALE signal, the CLE signal and the RE signal) to the memories 20A0 and 20A1 via the buses 50C and performs the write operation or the read operation. The strobe signal DQS and the data DQ#0-7 are transmitted between the device 300 and the memories 20A0 and 20A1 via the buses 50D and 50E of the circuit board 50, respectively.

The select controller 340 generates a select signal based on the output condition input from the control register 260 if the notification signal is input from the delay controller 230 in the observation operating state, and outputs the select signal to the signal selectors 250.

The select signal is used for causing at least one of the signal selectors 250 to select the trigger signal(s) instead of at least one of the command signals output from the ONFi controller 370.

The ONFi controller 370 outputs the busy signal to the select controller 340.

The select controller 340 does not output the select signal and abandons the trigger signal when the busy signal is H level. This means that the select controller 340 does not output the select signal when the busy signal is H level in a case where the trigger signals to which the delay periods corresponding to ten cycles of the system clock are given are input to the signal selectors 250 from the delay controller 230 after the satisfaction of the generating condition, for example.

Since the select controller 340 does not output the select signals to the signal selectors 250, the trigger signals input from the delay controller 230 to the signal selectors 250 are abandoned, even in a case where the trigger signals to which the delay periods are given are input from the delay controller 230 to the signal selectors 250.

The select controller 340 cancels an output operation of select signal in a case where the busy signal is H level even when the select controller 340 receives the notification signal from the delay controller 230. In this case, the select controller 340 outputs log information representing a timing at which the select controller 340 cancels the output operation of select signal to the log register 390. The log register 390 stores the log information output from the select controller 340.

The clock and the chip enable signals (CE0/1) output from the ONFi controller 370 and the command signals and/or the trigger signals output from the signal selectors 250 are input to the input/output buffer 380. The input/output buffer 380 transmits the data between the ONFi controller 370 and the memories 20A0 and 20A1.

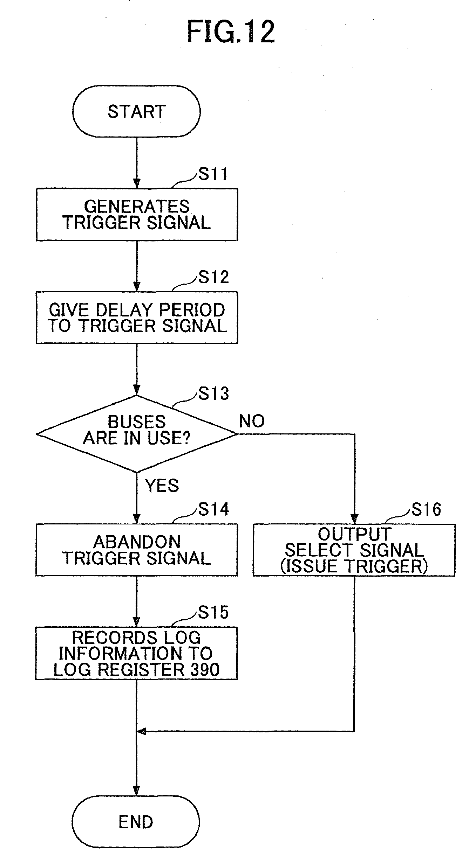

Hereinafter, a recording process of the log information performed by the device 300 of the third embodiment is described with reference to FIG. 12.

FIG. 12 is a flowchart illustrating the recording process of the log information performed by the device 300 of the third embodiment.

The trigger generator 220 generates a trigger signal (Trigger) based on the generating condition and a trigger pattern condition input from the control register 260 and the command signals and the data input from the ONFi controller 370 (step S11).

Next, the delay controller 230 gives the delay period to the trigger signals output from the trigger generator 220 and outputs the delayed trigger signal to the signal selectors 250. Further, the delay controller 230 controls the delay period based on the delay condition input from the control register 260 (step S12).

Next, the select controller 340 generates the select signal based on the output condition input from the control register 260 when the notification signal is input from the delay controller 230, and determines if the buses 50C are in use (step S13). The select controller 340 determines if the buses 50C are in use based on the signal level of the busy signal.

If the busy signal is H level (S13 : YES), the select controller 340 does not output the select signal and abandons the trigger signal (step S14). As a result, the signal selectors 250 do not select the trigger signals and select the ALE signal and the CLE signal. The ALE signal and the CLE signal are output from the terminals 201C.

Next, the select controller 340 records the log information representing the timing at which the select controller 340 cancels the output operation of select signal to the log register 390 (step S15).

If the select controller 340 determines that the busy signal is L level and that the buses 50C are not in use at step S13 (S13: NO), the select controller 340 outputs the select signals to the signal selectors 250 (step S16). As a result, the signal selectors 250 select the trigger signals instead of the ALE signal and the CLE signal, and output the trigger signals from the terminals 201C.

As described above, the log information is recorded in the log register 390 if the buses 50C are in use.

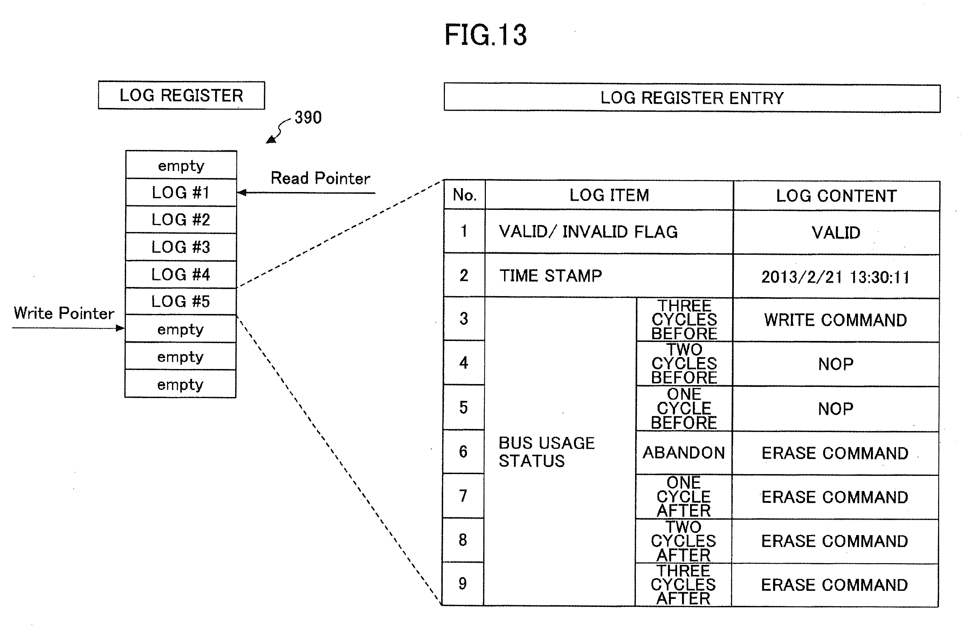

Next, the log information recorded in the log register 390 is described with reference to FIG. 13.

FIG. 13 is a diagram illustrating a configuration of the log register 390 and a data configuration of the log information. The log register 390 is one example of a record holder.

The log register 390 is a type of a ring buffer having a write operation pointer (Write Pointer) and a read operation pointer (Read Pointer) as illustrated on the left side in FIG. 13. FIG. 13 illustrates the ring buffer having nine areas to which the log information can be written, for example.

In Fig. 13, "empty" represents the area in which the log information is not written. The write operation pointer (Write Pointer) writes the log information to the nine areas in order. In FIG. 13, five logs #1-#5 are written in the five areas, respectively. The read operation pointer (Read Pointer) reads the log information in order. The area from which the log information is read by the read operation pointer (Read Pointer) becomes "empty".

On the right side of FIG. 13, one example of the log information of log #5 is illustrated as a log register entry. The log information is devided into a log item and a log content. The first (No.1) log item is valid/invalid flag. The second (No.2) log item is a time stamp. The third (No.3) to the ninth (No.9) log items are bus usage statuses.

According to the example as illustrated at the right side of FIG. 13, the valid/invalid is valid in the first (No.1) log item. The time stamp in the second (No.2) log item indicates 13:30:11 (thirteen hours thirty minutes and eleven seconds) on February 21, 2013 (2013/2/21). According to the bus usage statuses in the third (No.3) to the ninth (No.9) log items, the log content is the WRITE command at the timing three cycles before the trigger cancellation, and the log contents are NOPs at the timings two and one cycles before the trigger cancellation, respectively. Further, the log content is ERASE command at the timing of the trigger cancellation, and the log contents are ERASE commands at the timings one, two and three cycles after the trigger cancellation.

The user of the device 300 can find the unoccupied period of the buses 50C by analyzing the log information as described above. The user can find the unoccupied period of the buses 50C by adjusting the delay period and by obtaining the log information several times.

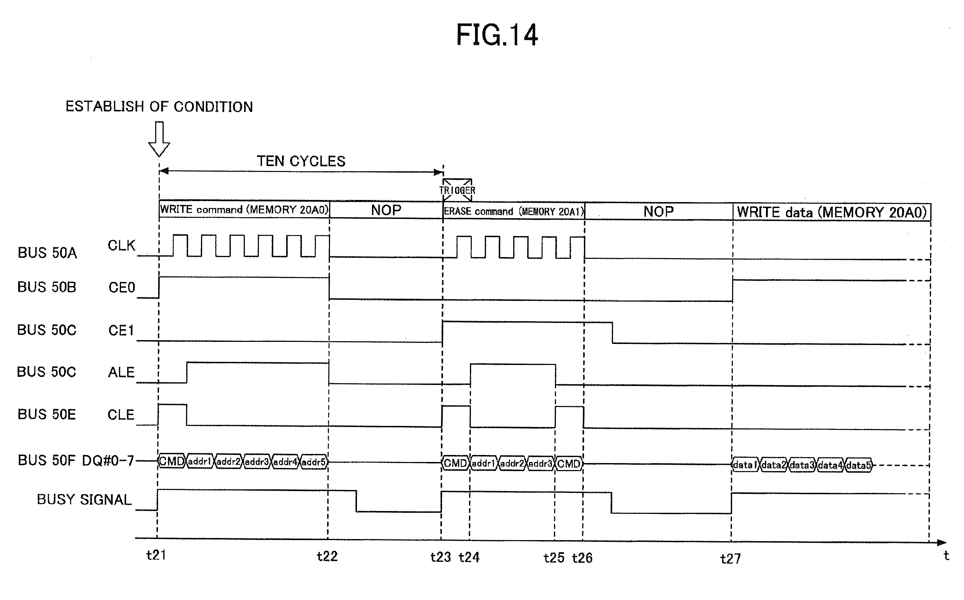

In the following, an operation of the device 300 in the observation operating state will be described with reference to FIG. 14.

FIG. 14 is a timing diagram illustrating the waveforms of the signals output from the device 300 of the third embodiment.

FIG. 14 illustrates the signals output from the terminals 201A, 201B, 201C and 201E to the buses 50A, 50B, 50C and 50E.

In the normal operating state, the device 300 outputs the clock CLK, the chip enable signals (CE0, CE1), the ALE signal, the CLE signal and the data DQ#0-7 from the terminals 201A, 201B, 201C and 201E to the buses 50A, 50B, 50C and 50E, respectively.

In FIG. 14, names of the signals that are output from the terminals 201A, 201B, 201C and 201E to the buses 50A, 50B, 50C, 50E in the normal operating state are illustrated as well.

Among those signals, the ALE signal, the CLE signal and the data DQ#0-7 are used for determining the satisfaction of the generating condition. The determination is performed by the trigger generator 220.

The busy signal is illustrated in FIG. 14. The H level busy signal indicates that as least one of the ALE signal and the CLE signal is transmitted through two of the buse(s) 50C. The L level busy signal indicates that neither the ALE signal nor the CLE signal is not transmitted through two of the buses 50C.

In FIG. 14, the operating states of the device 300 are indicated as "WRITE command" to the memory 20A0, "NOP", "ERASE command" to the memory 20A1 and "WRITE data" to the memory 20A0.

The "WRITE command" to the memory 20A0 indicates that the device 300 outputs the write operation command to the memory 20A0. The "NOP" indicates that the device 200 is not in operation. The "ERASE command" to the memory 20A1 indicates that the device 300 outputs an erase command to the memory 20A1. The "WRITE data" to the memory 20A0 indicates that the device 300 is writing the data into the memory 20A0.

As illustrated in FIG. 14, at time t21, the ALE signal and the CE1 signal are L level and the CE0 signal and the CLE signal transit from L level to H level. According to the ONFi protocol, a combination of the L level ALE signal and the H level CLE signal mean a command. Therefore, the data DQ#0-7 is treated as the command (CMD) during a period of time in which the ALE signal is L level and the CLE signal is H level.

At time t21, the busy signal transits to H level because a transmission of the command is started.

Since the write operation (WRITE) command is issued at time t21, the generating condition of the trigger signal is satisfied.

In the ONFi protocol, the issue of the write operation (WRITE) command is completed within ten cycles of the clock CLK.

After time t21, the address to which the write operation (WRITE) command is issued is designated as addr1, addr2, addr3, addr4 and addr5 with respect to each cycle over five cycles of the clock CLK. The issue of the write operation (WRITE) command is completed by the end of the sixth cycle of the clock CLK. At time t22, which is the beginning of the seventh cycle, the operating state of the device 300 turns to "NOP". Accordingly, the clock CLK stops as well. At a time point which is one cycle after time t22, the busy signal transits to L level.

The CE1 signal and the CLE signal transit to H level at time t23 ten cycles of the clock CLK after time t21 at which the generating condition of the trigger signal is satisfied. Accordingly, the busy signal transits to H level at time t23.

Since the CE1 signal and the CLE signal transit to H level at time t23, the ERASE command is issued to the memory 20A1.

Time t23 is ten cycles after time t21 at which the generating condition of the trigger signal is satisfied. Therefore, the trigger signals are output to two of the buses 50C corresponding to the ALE signal and the CLE signal, if the "ERASE command" is not issued to the memory 20A1.

However, the busy signal transits to H level at time t23. Therefore, the select controller 340 cancels the output operation of the select signal. As a result, the trigger signal is abandoned, and the log information (see FIG. 13) representing the abandoning of the trigger signal is recorded in the log register 390.

At time t24 one cycle after time t23, the ALE signal transits to H level and the CLE signal transits to L level. Accordingly, the address to which the erase (ERASE) command is issued is designated as addr1, addr2 and addr3 with respect to each cycle over three cycles of the clock CLK.

At time t25, the ALE signal transits to L level and the CLE signal transits to H level. Therefore, a second erase command which represents termination of the erase (ERASE) command is issued, and the issue of the erase (ERASE) command terminates at time t26 one cycle after time t25. At a time point which is one cycle after time t26, the busy signal transits to L level.

After time t27, data data1, data2, data3, data4 and data5 are written to the addresses indicated as addr1, addr2, addr3, addr4 and addr5, respectively. Time t27 is the designated period of time after the completion of the issue of the write operation (WRITE) command to the memory 20A0.

According to the third embodiment, the issue of the trigger signal is cancelled, if the buses 50C are busy at timing at which the trigger signal is to be issued.

This is for the sake of avoiding the collision of the command and the trigger signal. In the operation example as illustrated in FIG. 14, the device 300 abandons the trigger signal because the erase (ERASE) command is issued at time t23 at which the trigger signal is to be issued.

The device 300 records the log information at the timing at which the device 300 abandoned the trigger signal to the log register 390.

The user of the device 300 can find the unoccupied period of the buses 50C by analyzing the log information recorded in the log register 390 as described above. The user can find the unoccupied period of the buses 50C by adjusting the delay period and by obtaining the log information several times.

Accordingly, the device 300 of the third embodiment can provide appropriate information about the unoccupied period of the buses 50C to the user. As a result, the user can make the device 300 output the trigger signal to the buses 50C without fail. This means that the utilization efficiency is improved even more.

According to the device 300 of the third embodiment, it is possible to output the trigger signals from the two terminals 201C in the observation operating state from which the ALE signal and the CLE signal are output in the normal operating state.

Therefore, it is not necessary to provide the terminal 10E which is used only for outputting the trigger signal as described with regard to the device 10 of the comparative example.

Accordingly, it is possible to provide the device 300 which has improved utilization efficiency according to the third embodiment.

As a result, it is possible to detect the trigger signal by two of the probes P1, P2, P3 and P4, to detect the four signals that are transmitted through two of the buses 50C, one of the buses 50D and one of the buses 50E via the probes P1, P2, P3 and P4 and to observe the four signals on the oscilloscope 30A.

Accordingly, the device 300 of the third embodiment can provide appropriate information about the unoccupied period of the buses 50C to the user. As a result, the user can cause the device 300 to output the trigger signal to the buses 50C without fail. Accordingly, it is possible to improve the utilization efficiency even more.

So far, the preferred embodiments and modification of the semiconductor circuit apparatus and electronic apparatus are described. However, the invention is not limited to those specifically described embodiments and the modification thereof, and various modifications and alteration may be made within the scope of the inventions described in the claims.

## Claims

1. A semiconductor circuit apparatus (100) comprising:
a main controller (110) configured to output a control signal;
an outputting part (101C) configured to output the control signal outside of the semiconductor circuit apparatus (100);
a condition holding part (260) configured to hold a generating condition and an output condition of a trigger signal;
a trigger signal generator (120) configured to generate the trigger signal, if the control signal satisfies the generating condition;
a delay controller (130) configured to give a delay to the trigger signal based on the output condition; and
a selector (140, 150) configured to be disposed between the main controller (110) and the outputting part (101C) and to selectively output the trigger signal delayed at the delay controller (130) to the outputting part (101C) instead of the control signal output from the main controller (110) based on the output condition.

2. The semiconductor circuit apparatus (100) as claimed in claim 1, the selector (140, 150) including:
a selecting circuit (150) configured to be disposed between the main controller (110) and the outputting part (101C), to receive the control signal and the delayed trigger signal and to output the control signal or the delayed trigger signal, and
a select controller (140) configured to generate a select signal based on the output condition and to output the select signal to the selecting circuit (150), the select signal causing the selecting circuit (150) to select the control signal or the delayed trigger signal.

3. The semiconductor circuit apparatus (100) as claimed in claim 2, wherein the selector (140, 150) further includes a record holder (390) configured to hold an output-record of the select signal input to the selecting circuit (150).

4. The semiconductor circuit apparatus (100) as claimed in claim 3, wherein the select controller (140) is configured to output the select signal causing the selecting circuit (150) to select the control signal when the delayed trigger signal is output from the delay controller (130), if the select controller (140) receives a first notification signal indicating that the outputting part (101C) is in use from the main controller (110).

5. The semiconductor circuit apparatus (100) as claimed in claim 4, wherein the delay controller (130) transmits a second notification signal to the select controller (140) in a case where the delay controller (130) outputs the delayed trigger signal to the selector (140, 150), the second notification signal indicating that the delay controller (130) outputs the delayed trigger signal, and
wherein the select controller (140) outputs the select signal to the selecting circuit (150) causing the selecting circuit (150) to select the control signal when the select controller (140) receives the second notification signal from the delay controller (130), if the select controller (140) receives the first notification signal from the main controller (110).

6. An electronic apparatus comprising:
the semiconductor circuit apparatus (100) as claimed in any one of claims 1 to 5;
a circuit board configured to include a trace connected to the outputting part (101C), the semiconductor circuit apparatus (100) being mounted on the circuit board; and
a second semiconductor circuit apparatus (100) configured to be mounted on the circuit board and connected to the semiconductor circuit apparatus (100) as claimed in any one of claims 1 to 5 via the trace;
wherein the delayed trigger signal which is selected by the selector (140, 150) instead of the control signal is output to the trace from the outputting part (101C).

7. The electronic apparatus as claimed in claim 6, further comprising a probe terminal provided on the trace.
